# EUROPEAN PATENT APPLICATION

(11) **EP 4 851 981 A1**
(43) Date of publication of application: **09.12.2026**
(21) Application number: 24949023.6
(22) Date of filing: 30.07.2024
(51) Int. Cl.: G09G 3/20, G11C 19/28

(54) **SHIFT REGISTER, DRIVING CIRCUIT, DRIVING METHOD, AND DISPLAY DEVICE**

(71) Applicant: Boe Technology Group Co., Ltd., Beijing 100015 (CN); Beijing BOE Technology Development Co., Ltd., Daxing District Beijing 100176 (CN)
(72) Inventor: SHANG, Guangliang, Beijing 100176 (CN); LU, Jiangnan, Beijing 100176 (CN); ZHU, Jianchao, Beijing 100176 (CN); LIU, Miao, Beijing 100176 (CN); FENG, Yu, Beijing 100176 (CN)
(74) Representative: AWA Sweden AB
(86) International application number: PCT/CN2024/108413
(87) International publication number: WO 2026/025276

(57) **Abstract**

The present disclosure provides a shift register, a driving circuit, a driving method and a display device, which relate to a field of display technology. The shift register includes: an input shift circuit, configured to control a potential of a first node using a first clock signal from a first clock terminal, a second clock signal from a second clock terminal, a first input signal from a first input terminal and a reset signal from a reset terminal, and to control a potential of a second node using a third clock signal from a third clock terminal, a fourth clock signal from a fourth clock terminal and the potential of the first node; a first control circuit, configured to control a potential of a third node using the potential of the second node and a first control signal from a first control terminal; and an output circuit, configured to control whether to provide a first power supply voltage from a first power supply or a second power supply voltage from a second power supply to an output terminal as an output signal, based on the potential of the first node and the potential of the third node.

## Description

### TECHNICAL FIELD

The present disclosure relates to a field of display technology, and in particular to a shift register, a driving circuit, a driving method, and a display device.

### BACKGROUND

Gate driver on array (GOA) technology is a technique for integrating driving circuits onto a display panel, which may facilitate a narrow-bezel design of the display panel. The driving circuits may provide signals such as scan signals, emission control signals and reset signals to pixel circuits in the display panel to drive the pixel circuits.

In a conventional complementary metal oxide semiconductor (CMOS) GOA circuit, a P-type MOS transistor and an N-type MOS transistor are controlled by the same signal, so that the P-type MOS transistor and the N-type MOS transistor may be turned on simultaneously when the signal is in an intermediate state. In this case, a leakage current may occur between a power supply connected to the P-type MOS transistor and a power supply connected to the N-type MOS transistor, thereby increasing a power consumption of the GOA circuit and reducing a driving capability for the pixel circuits.

### SUMMARY

To solve the above problems, the present disclosure provides a shift register, a driving circuit, a driving method, and a display device.

According to a first aspect, the present disclosure provides a shift register, including: an input shift circuit, configured to control a potential of a first node using a first clock signal from a first clock terminal, a second clock signal from a second clock terminal, a first input signal from a first input terminal and a reset signal from a reset terminal, and to control a potential of a second node using a third clock signal from a third clock terminal, a fourth clock signal from a fourth clock terminal and the potential of the first node; a first control circuit, configured to control a potential of a third node using the potential of the second node and a first control signal from a first control terminal; and an output circuit, configured to control whether to provide a first power supply voltage from a first power supply or a second power supply voltage from a second power supply to an output terminal as an output signal, based on the potential of the first node and the potential of the third node.

According to a second aspect, the present disclosure provides a driving circuit, including M cascaded shift registers according to embodiments of the present disclosure, where the first input terminal of an m^{th} stage shift register is electrically connected to the second node of an (m-1)^{th} stage shift register, 2 < m ≤ M, m and M are integers.

According to a third aspect, the present disclosure provides a display device, including the driving circuit according to embodiments of the present disclosure.

According to a fourth aspect, the present disclosure provides a driving method applied to any shift register according to embodiments of the present disclosure, including: controlling the first input signal to be at a first level, the reset signal to be at the first level, and the first control signal to be at the first level in a first time period; controlling the first input signal to be at the first level, the reset signal to be at the first level, and the first control signal to be at a second level in a second time period; controlling the first input signal to be at the second level, the reset signal to be at the first level, and the first control signal to be at the first level in a third time period; and controlling the first input signal to be at the second level, the reset signal to be at the first level, and the first control signal to be at the second level in a fourth time period.

### BRIEF DESCRIPTION OF THE DRAWINGS

FIG. 1A shows a schematic structural diagram of an exemplary pixel circuit;
FIG. 1B shows a signal timing diagram of the pixel circuit shown in FIG. 1A;
FIG. 2 shows a schematic structural diagram of a shift register according to an embodiment of the present disclosure;
FIG. 3 shows a schematic structural diagram of a shift register according to another embodiment of the present disclosure;
FIG. 4 shows a schematic structural diagram of a shift register according to another embodiment of the present disclosure;
FIG. 5 shows a schematic structural diagram of a shift register according to another embodiment of the present disclosure;
FIG. 6 shows a schematic structural diagram of a shift register according to another embodiment of the present disclosure;
FIG. 7 shows a schematic structural diagram of a shift register according to another embodiment of the present disclosure;
FIG. 8A shows a schematic structural diagram of a shift register according to another embodiment of the present disclosure;
FIG. 8B shows a signal timing diagram of a shift register according to an embodiment of the present disclosure;
FIG. 9 shows a schematic structural diagram of a shift register according to another embodiment of the present disclosure;
FIG. 10A shows a schematic structural diagram of a shift register according to another embodiment of the present disclosure;
FIG. 10B shows a signal timing diagram of a shift register according to an embodiment of the present disclosure;
FIG. 11 shows a schematic structural diagram of a shift register according to another embodiment of the present disclosure;
FIG. 12A shows a schematic structural diagram of a shift register according to another embodiment of the present disclosure;
FIG. 12B shows a signal timing diagram of a shift register according to another embodiment of the present disclosure;
FIG. 12C shows a signal timing diagram of a shift register according to another embodiment of the present disclosure;
FIG. 13 shows a schematic structural diagram of a shift register according to another embodiment of the present disclosure;
FIG. 14 shows a schematic structural diagram of a shift register according to another embodiment of the present disclosure;
FIG. 15 shows a schematic structural diagram of a shift register according to another embodiment of the present disclosure;
FIG. 16 shows a signal timing diagram of a shift register according to another embodiment of the present disclosure;
FIG. 17A and FIG. 17B show schematic current diagrams of an exemplary shift register;
FIG. 18A and FIG. 18B shows schematic current diagrams of a shift register according to an embodiment of the present disclosure;
FIG. 19 shows a schematic structural diagram of a driving circuit according to an embodiment of the present disclosure;
FIG. 20 shows a schematic structural diagram of a driving circuit according to another embodiment of the present disclosure;
FIG. 21 shows a schematic structural diagram of a display device according to an embodiment of the present disclosure; and
FIG. 22 shows a flowchart of a driving method according to an embodiment of the present disclosure.

### DETAILED DESCRIPTION OF EMBODIMENTS

To make objectives, technical solutions and advantages of embodiments of the present disclosure clearer, technical solutions In an embodiment of the present disclosure will be clearly and completely described below with reference to the accompanying drawings In an embodiment of the present disclosure. Obviously, the described embodiments are some, but not all, of embodiments of the present disclosure. All additional embodiments obtained by those ordinary skilled in the art without inventive efforts based on the described embodiments of the present disclosure fall within the protection scope of the present disclosure. It should be noted that, throughout the accompanying drawings, the same or similar reference numerals denote the same or similar elements. In the following description, some specific embodiments are turned only for illustrative purposes and should not be construed as any limitation to the present disclosure, but are merely examples of embodiments of the present disclosure. Conventional structures or configurations may be omitted when they may cause confusion in understanding the present disclosure. It should be noted that the shapes and sizes of components in the accompanying drawings do not reflect actual sizes and proportions, but merely illustrate the contents of embodiments of the present disclosure.

Unless otherwise defined, technical or scientific terms used In an embodiment of the present disclosure should have the ordinary meanings as understood by those skilled in the art. The terms "first", "second" and similar words used In an embodiment of the present disclosure do not indicate any order, quantity or importance, but are turned only used to distinguish different components.

Furthermore, in the description of embodiments of the present disclosure, the term "connected to" or "coupled to" may mean that two components are directly connected, or that two components are connected through one or more other components. In addition, the two components may be connected or coupled in a wired or wireless manner.

In an embodiment of the present disclosure, a source electrode and a drain electrode of a switching transistor are symmetric, so the source electrode and the drain electrode may be interchanged. In an embodiment of the present disclosure, according to corresponding functions, a gate electrode may be referred to as a control electrode, one of the source electrode and the drain electrode may be referred to as a first electrode, and the other of the source electrode and the drain electrode may be referred to as a second electrode.

Furthermore, in the description of embodiments of the present disclosure, the terms "first power supply voltage" and "second power supply voltage" are turned only used to distinguish magnitudes of two power supply voltages. For example, in the following description, the "first power supply voltage" is a relatively high voltage, and the "second power supply voltage" and "third power supply voltage" are relatively low voltages. It may be understood by those skilled in the art that the present disclosure is not limited thereto.

It should be noted that, in the description of embodiments of the present disclosure, INPUT1 may represent either a first input signal terminal or a first input signal provided by the first input terminal. Similarly, CB may represent either a first clock terminal or a first clock signal provided by the first clock terminal, OUT may represent either a first output terminal or a first output signal output by the first output terminal, and VGH1 and VGL1 may represent either power supplies or power supply voltages provided by the power supplies. For example, the power supply VGH1 may provide a high-level voltage, and the power supply VGL1 may provide a low-level voltage. The same applies to the following embodiments and will not be repeated.

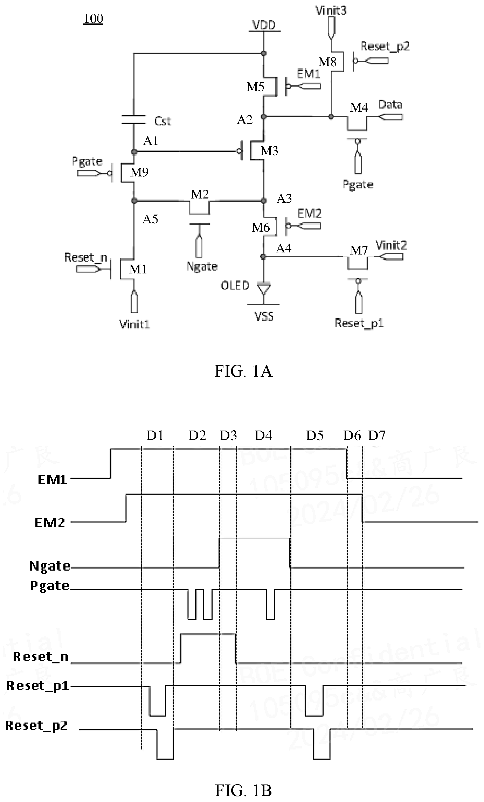

FIG. 1A shows a schematic structural diagram of an exemplary pixel circuit, and FIG. 1B shows a signal timing diagram of the pixel circuit shown in FIG. 1A.

FIG. 1A shows an OLED pixel circuit 100, which is a 9T1C circuit. The pixel circuit 100 includes transistor M1 to transistor M9 and capacitor Cst. In the pixel circuit 100, transistor M4 and transistor M9 share a scan signal Pgate.

As shown in FIG. 1B, when the pixel circuit 100 is being charged, emission control signals EM1 and EM2 are at high level, transistor M5 and transistor M6 are turned off, and a light emission of a light-emitting element OLED is disabled.

In phase D1, reset signals Reset_p1 and Reset_p2 are at low level, transistor M7 and transistor M8 are turned on, then initialization signal Vinit2 is written to node A4, and initialization signal Vinit3 is written to node A2.

In phase D2, reset signals Reset_p1 and Reset_p2 are at high level, and transistor M7 and transistor M8 are turned off; reset signal Reset_n is at a high level, scan signal Pgate is at a low level, and transistor M1, transistor M9, transistor M3 and transistor M4 are turned on, then initialization signal Vinit1 is written to node A1, and data signal Data is written to node A2 and node A3.

In phase D3, scan signal Ngate is at a high level, and transistor M9 and transistor M4 are turned off; scan signal Ngate is at a high level, reset signal Reset_n remains at a high level, and transistor M1 and transistor M2 are turned on, then initialization signal Vinit1 is written to node A3.

In phase D4, scan signal Ngate remains at a high level, reset signal Reset_n transitions to a low level, and scan signal Pgate transitions to a low level, then transistor M2, transistor M4 and transistor M9 are turned on, and data signal Data is written to node A2, node A3, node A5 and node A1. After the charging of the capacitor Cst is completed, a potential of node A3 and a potential of node A1 are Vdata+Vth_Td, where Vdata represents a voltage of the data signal Data, and Vth_Td represents a threshold voltage of transistor M3.

In phase D5, scan signal Ngate is at a low level, scan signal PGate is at a high level, and transistor M2, transistor M4 and transistor M9 are turned off. Reset signals Reset_p1 and Reset_p2 are at low level, and transistor M7 and transistor M8 are turned on, then initialization signal Vinit2 is written to node A4, and initialization signal Vinit3 is written to node A2. If Vinit3>Vdata, the potential of node A3 is Vinit3+Vth_Td; otherwise, the potential of node A3 remains unchanged.

In phase D6, reset signals Reset_p1 and Reset_p2 are at high level, transistor M7 and transistor M8 are turned off; emission control signal EM1 is at a low level, and transistor M5 is turned on. If a pull-up power supply voltage VDD is greater than Vdata, the potential of node A3 is VDD+Vth_Td; otherwise, the potential of node A3 remains unchanged.

In phase D7, emission control signal EM2 is at a low level, transistor M6 is turned on, and the light-emitting element OLED emits light. An emission current is determined by a voltage between node A1 and node A2. The potential of node A1 is Vdata+Vth_Td and the potential of node A2 is VDD, then the emission current Id is Id=K(Vdata-VDD)², where K is determined by TFT characteristics such as W/L, Cox, and mu.

The scan signals Ngate and Pgate, the reset signals Reset_p1, Reset_p2 and Reset_n, and the emission control signals EM1 and EM2 may all be provided by a GOA circuit. When a leakage current occurs in the GOA circuit, a driving capability of the GOA circuit for the pixel circuit 100 may be reduced, which affects a light-emitting effect of the light-emitting element OLED.

The present disclosure provides a shift register, and a plurality of shift registers in cascade may respectively provide scan signals, reset signals, emission control signals, etc., for pixel circuits of multiple pixel rows in a display panel. In the shift register provided by the present disclosure, it is possible to prevent simultaneous turn-on of PMOS and NMOS in an output circuit by controlling turn-on timing point and turn-off timing point of the PMOS and the NMOS, which may prevent an occurrence of instantaneous large current between a high power supply and a low power supply electrically connected to the PMOS and the NMOS, thereby reducing the power consumption of the GOA circuit and enhancing the driving capability for the pixel circuit.

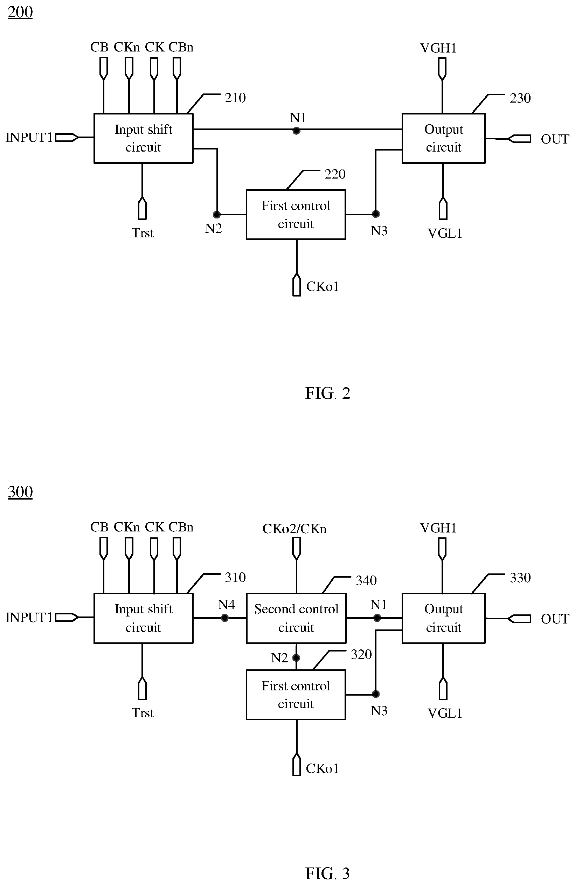

FIG. 2 shows a schematic structural diagram of a shift register according to an embodiment of the present disclosure.

As shown in FIG. 2, a shift register 200 includes an input shift circuit 210, a first control circuit 220, and an output circuit 230.

In an embodiment of the present disclosure, the input shift circuit 210 is electrically connected to a first input terminal INPUT1, a first clock terminal CB, a second clock terminal CKn, a third clock terminal CK, a fourth clock terminal CBn, and a reset terminal Trst.

The input shift circuit 210 may control a potential of a first node N1 using a first clock signal CB from the first clock terminal CB, a second clock signal CKn from the second clock terminal CKn, a first input signal INPUT1 from the first input terminal INPUT1, and a reset signal Trst from the reset terminal Trst. The input shift circuit 210 may further control a potential of a second node N2 using a third clock signal CK from the third clock terminal CK, a fourth clock signal CBn from the fourth clock terminal CBn, and the potential of the first node N1.

For example, under the control of the first clock signal CB and the second clock signal CKn, the input shift circuit 210 may control the potential of the first node N1 using a level of the reset signal Trst and a level of the first input signal INPUT1. When the first clock signal CB and the second clock signal CKn control the input shift circuit 210 to be in an on state, the first input signal INPUT1 is written into the input shift circuit 210. The input shift circuit 210 may control the potential of the first node N1 based on the level of the reset signal Trst and the level of the first input signal INPUT1. For example, when at least one of the reset signal Trst and the first input signal INPUT1 is at a high level, the input shift circuit 210 controls the potential of the first node N1 to be at a low level. When both the reset signal Trst and the first input signal INPUT1 are at low level, the input shift circuit 210 controls the potential of the first node N1 to be at a high level.

For example, the first clock signal CB, the second clock signal CKn, the third clock signal CK and the fourth clock signal CBn may jointly control whether the first input terminal INPUT1 and the second node N2 are in a connected state or a disconnected state. When the first clock signal CB, the second clock signal CKn, the third clock signal CK and the fourth clock signal CBn control the first input terminal INPUT1 and the second node N2 to be in a disconnected state, the input shift circuit 210 controls the potential of the second node N2 based on the potential of the first node N1. For example, the input shift circuit 210 may control the potential of the second node N2 to be the inverse of the potential of the first node N1. When the potential of the first node N1 is at a high level, the input shift circuit 210 may control the potential of the second node N2 to be at a low level. When the potential of the first node N1 is at a low level, the input shift circuit 210 may control the potential of the second node N2 to be at a high level.

In an embodiment of the present disclosure, the second node N2 may be a shift node, which is used to provide a shift signal. The shift signal provided by the second node N2 is provided to the first input terminal of a next-stage shift register in the cascade, so as to provide a first input signal for the next-stage shift register.

In an embodiment of the present disclosure, the first control circuit 220 is electrically connected to the first node N1, a third node N3, and a first control terminal CKo1.

The first control circuit 220 may control a potential of the third node N3 using the potential of the second node N2 and a first control signal CKo1 from the first control terminal CKo1. The first control circuit 220 may control the potential of the third node N3 using the potential of the second node N2 and a level of the first control signal CKo1. For example, when at least one of the potential of the second node N2 and the level of the first control signal CKo1 is at a high level, the first control circuit 220 controls the potential of the third node N3 to be at a low level. When both the potential of the second node N2 and the level of the first control signal CKo1 are at low level, the first control circuit 220 controls the potential of the third node N3 to be at a high level.

In an embodiment of the present disclosure, the output circuit 230 is electrically connected to the first node N1, the third node N3, a first power supply VGH1, a second power supply VGL1, and an output terminal OUT. The output circuit 230 may control whether to provide a first power supply voltage VGH1 of the first power supply VGH1 or a second power supply voltage VGL1 of the second power supply VGL1 to the output terminal OUT as an output signal OUT by using the potential of the first node N1 and the potential of the third node N3. The output signal OUT may be a scan signal, a reset signal, an emission control signal, etc., provided to the pixel circuit.

The first node N1 is a pull-up node, and the third node N3 is a pull-down node. For example, the potential of the first node N1 may be used to control whether the first power supply VGH1 and the output terminal OUT are in a connected state or a disconnected state. When the first power supply VGH1 and the output terminal OUT are in a connected state, the output circuit 230 provides the first power supply voltage VGH1 to the output terminal OUT, the first power supply voltage VGH1 pulls up a potential of the output terminal OUT, and a high-level signal is output. The potential of the third node N3 may be used to control whether the second power supply VGL1 and the output terminal OUT are in a connected state or a disconnected state. When the second power supply VGL1 and the output terminal OUT are in a connected state, the output circuit 230 provides the second power supply voltage VGL1 to the output terminal OUT, the second power supply voltage VGL1 pulls down the potential of the output terminal OUT, and a low-level signal is output.

In an embodiment of the present disclosure, the connected state and the disconnected state between the first power supply VGH1 and the output terminal OUT are controlled using the potential of the first node N1, while the connected state and the disconnected state between the second power supply VGL1 and the output terminal OUT are controlled using the potential of the third node N3, which may avoid the first power supply VGH1 and the second power supply VGL1 being simultaneously connected to the output terminal OUT, thereby avoiding an occurrence of instantaneous large current between the first power supply VGH1 and the second power supply VGL1.

The potential of the first node N1 is controlled by level changes of the first input signal INPUT1, the first clock signal CB, the second clock signal CKn and the reset signal Trst. During a power-on/power-off or blanking phase of the shift register, the reset signal Trst may be set to a high level to reset the output terminal OUT and control the potential of the output terminal OUT to be at a high level. During a normal display phase, the reset signal Trst may stably remain at a low level. In this case, the potential of the first node N1 is affected by the level of the first input signal INPUT1 that is written in, and the first clock signal CB and the second clock signal CKn may control a timing point at which the first input signal INPUT1 is written to the input shift circuit 210, thereby controlling a timing point of a potential change of the first node N1.

The potential of the third node N3 is controlled by the potential of the second node N2 and the level change of the first control signal CKo, and the potential of the second node N2 is determined based on the potential of the first node N1. When the potential of the first node N1 is determined, it is possible to control the potential of the third node N3 by controlling the level change of the first control signal CKo1. Therefore, it is possible to control the timing point of the potential change of the third node N3 by controlling the timing point of the level change of the first control signal CKo1.

In an embodiment of the present disclosure, by controlling the pull-up node and the pull-down node respectively through the first node N1 and the third node N3, the connected/disconnected state between the first power supply VGH1 and the output terminal OUT and the connected/disconnected state between the second power supply VGL1 and the output terminal OUT may be controlled separately. Through the level changes of the first clock signal CB, the second clock signal CKn and the first control signal CKo1, the timing point of the potential change of the first node N1 and the timing point of the potential change of the third node N3 may be controlled. For example, when controlling the level of the first control signal CKo1 not to change synchronously with the level of the first clock signal CB or the level of the second clock signal CKn, the potential of the first node N1 and the potential of the third node N3 may not change synchronously, thereby avoiding the first power supply VGH1 and the second power supply VGL1 being simultaneously connected to the output terminal OUT.

For example, when the second power supply VGL1 and the output terminal OUT are in a disconnected state, it is possible to control the first power supply VGH1 and the output terminal OUT to be in a connected state using the potential of the first node N1, so that the output terminal OUT stably outputs a high-level output signal OUT. After the potential of the first node N1 is used to control the first power supply VGH1 and the output terminal OUT to be in a disconnected state, it is possible to control the second power supply VGL1 and the output terminal OUT to be in a connected state using the potential of the third node N3, so that the output terminal OUT stably outputs a low-level output signal OUT. After the connected state between the second power supply VGL1 and the output terminal OUT switches to a disconnected state, it is possible to control the first power supply VGH1 and the output terminal OUT to be in a connected state again using the potential of the first node N1. In this case, by controlling the timing point of the potential change of the first node N1 and the timing point of the potential change of the third node N3, it is possible to avoid an occurrence of instantaneous large current between the first power supply VGH1 and the second power supply VGL1, thereby reducing the power consumption of the shift register 100 and improving the driving capability.

FIG. 3 shows a schematic structural diagram of a shift register according to another embodiment of the present disclosure.

As shown in FIG. 3, a shift register 300 includes an input shift circuit 310, a first control circuit 320, an output circuit 330, and a second control circuit 340.

The input shift circuit 310, the first control circuit 320 and the output circuit 330 are respectively similar to the input shift circuit 210, the first control circuit 220 and the output circuit 230 described above. For conciseness, details will not be repeated here.

In an embodiment of the present disclosure, the second control circuit 340 is electrically connected to a fourth node N4, the first node N1 and a second control terminal CKo2, or the second control circuit 340 is electrically connected to the fourth node N4, the first node N1 and the second clock terminal CKn. The second control circuit 340 may control the potential of the first node N1 using a potential of the fourth node N4 and a second control signal CKo2 from the second control terminal CKo2, or control the potential of the first node N1 using the second clock signal CKn and the potential of the fourth node N4.

The input shift circuit 310 is electrically connected to the fourth node N4. The input shift circuit 310 may control the potential of the fourth node N4 using the first clock signal CB, the second clock signal CKn, the first input signal INPUT1 and the reset signal Trst.

In an embodiment of the present disclosure, the second control circuit 340 is further electrically connected to the second node N2. The second control circuit 340 may control the potential of the second node N2 using the potential of the fourth node N4. For example, the second control circuit 340 may control the potential of the second node N2 to be the inverse of the potential of the fourth node N4. When the potential of the fourth node N4 is at a high level, the second control circuit 340 may control the potential of the second node N2 to be at a low level. When the potential of the fourth node N4 is at a low level, the second control circuit 340 may control the potential of the second node N2 to be at a high level.

The timing point of the potential change of the first node N1 is controlled by the second control signal CKo2 and the potential of the second node N2, or by the second clock signal CKn and the potential of the second node N2. When the potential of the second node N2 is determined based on the potential of the first node N1, it is possible to control the timing point of the potential change of the first node N1 by controlling the timing point of the level change of the second control signal CKo2 or the second clock signal CKn, so as to control the timing point of the disconnected state or the connected state between the first power supply VGH1 and the output terminal OUT.

The timing point of the potential change of the third node N3 is controlled by the first control signal CKo1 and the potential of the second node N2. When the potential of the second node N2 is determined based on the potential of the first node N1, it is possible to control the timing point of the potential change of the third node N3 by controlling the timing point of the level change of the first control signal CKo1, so as to control the timing point of the disconnected state or the connected state between the second power supply VGL1 and the output terminal OUT.

In an embodiments of the present disclosure, through the level change of the second control signal CKo2 or the second clock signal CKn in combination with the level change of the first control signal CKo1, when the first input signal INPUT1 is a multi-pulse signal, the output terminal OUT may output a multi-pulse output signal OUT.

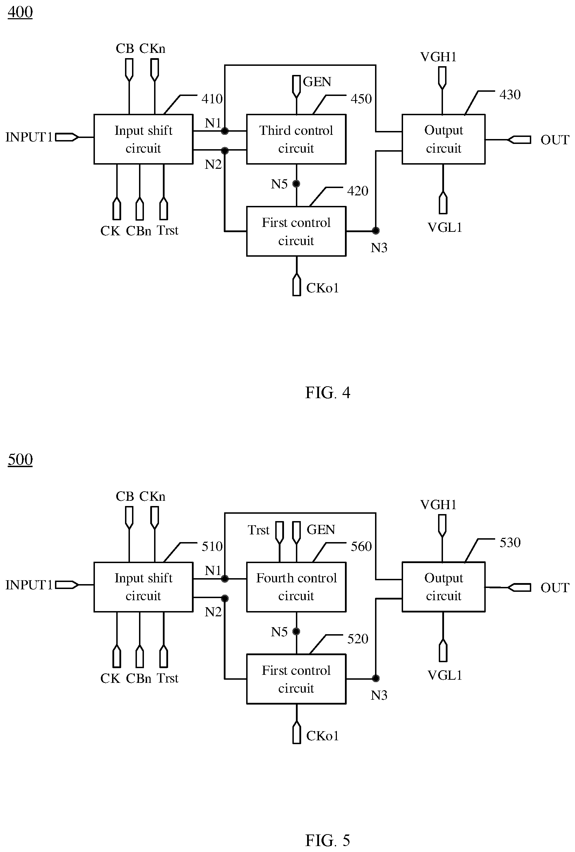

FIG. 4 shows a schematic structural diagram of a shift register according to another embodiment of the present disclosure.

As shown in FIG. 4, a shift register 400 includes an input shift circuit 410, a first control circuit 420, an output circuit 430, and a third control circuit 450.

The input shift circuit 410, the first control circuit 420 and the output circuit 430 are respectively similar to the input shift circuit 210, the first control circuit 220 and the output circuit 230 described above. For conciseness, details will not be repeated here.

In an embodiment of the present disclosure, the third control circuit 450 is electrically connected to an enable terminal GEN, the first node N1 and the second node N2. The third control circuit 450 may control the potential of the fifth node N5 using the potential of the first node N1, the potential of the second node N2, and an enable signal GEN from the enable terminal GEN. The first control circuit 420 is electrically connected to the fifth node N5. The first control circuit 420 may control the potential of the third node N3 using the potential of the fifth node N5, the potential of the second node N2, and the first control signal CKo1.

In an embodiment of the present disclosure, the enable signal GEN may control the output signal OUT from the output terminal OUT to perform partial refreshes on the pixel circuit. For example, the output signal OUT may be a scan signal used to drive a P-type transistor in the pixel circuit. For example, when the input signal OUT is at a low level, the P-type transistor is turned on, and a data signal is allowed to be written in, thereby achieve image refresh. When the output signal OUT is at a high level, the P-type transistor is turned off, and the data signal is not allowed to be written in, thereby maintaining the image without refresh.

In an embodiment of the present disclosure, the enable signal GEN may control the potential of the third node N3 by controlling the potential of the fifth node N5. Based on the potential of the third node N3, the output terminal OUT may be controlled to output a high-level signal or a low-level signal to control whether the transistor in the pixel circuit is turned on, thereby achieving image refresh or image retention.

In an embodiment of the present disclosure, the potential of the first node N1 and the potential of the second node N2 may be used to control the enable terminal GEN and the fifth node N5 to be in a connected state or a disconnected state. When the potential of the first node N1 and the potential of the second node N2 are used to control the enable terminal GEN and the fifth node N5 to be in a connected state, the third control circuit 450 writes the enable signal GEN to the fifth node N5.

In an embodiment of the present disclosure, the first control circuit 420 may control the potential of the third node N3 based on the level of three signals, as shown in FIG. 4. For example, when at least one of the potential of the second node N2, the potential of the fifth node N5 and the first control signal CKo1 is at a high level, the first control circuit 420 controls the potential of the third node N3 to be at a low level. When the potential of the second node N2, the potential of the fifth node N5 and the first control signal CKo1 are all at low level, the first control circuit 420 controls the potential of the third node N3 to be at a high level. For example, in this case, when the timing of the enable signal GEN remains at a low level, the corresponding pixel circuit may be refreshed; when the timing of the enable signal GEN remains at a high level, the corresponding pixel circuit is not refreshed.

In an embodiment of the present disclosure, the first control circuit 420 may control the potential of the third node N3 based solely on the level of two signals. For example, when at least one the potential of the second node N2 and the potential of the fifth node N5 is at a high level, the first control circuit 420 controls the potential of the third node N3 to be at a low level. When both the potential of the second node N2 and the potential of the fifth node N5 are at low level, the first control circuit 420 controls the potential of the third node N3 to be at a high level. For example, in this case, when the timing of the enable signal GEN changes in synchronization with the timing of the first control signal CKo1, the corresponding pixel circuit is refreshed. When the timing of the enable signal GEN remains at a high level, the corresponding pixel circuit is not refreshed.

FIG. 5 shows a schematic structural diagram of a shift register according to another embodiment of the present disclosure.

As shown in FIG. 5, a shift register 500 includes an input shift circuit 510, a first control circuit 520, an output circuit 530, and a fourth control circuit 560.

The input shift circuit 510, the first control circuit 520 and the output circuit 530 are respectively similar to the input shift circuit 210, the first control circuit 220 and the output circuit 230 described above. For conciseness, details will not be repeated here.

In an embodiment of the present disclosure, the fourth control circuit 560 is electrically connected to the first node N1, the reset terminal Trst, the enable terminal GEN and the fifth node N5. The fourth control circuit 560 may control the potential of the fifth node N5 using the potential of the first node N1, the reset signal Trst, and the enable signal GEN from the enable terminal GEN.

In an embodiment of the present disclosure, the potential of the first node N1 and the level of the reset signal Trst may be used to control whether the enable terminal GEN and the fifth node N5 are in a connected state or a disconnected state. When the potential of the first node N1 and the level of the reset signal Trst are used to control the enable terminal GEN and the fifth node N5 to be in a connected state, the fourth control circuit 560 writes the enable signal GEN to the fifth node N5. The enable signal GEN controls the potential of the third node N3 by controlling the potential of the fifth node N5. Based on the potential of the third node N3, the output terminal OUT may be controlled to output a high-level signal or a low-level signal to control whether the transistor in the pixel circuit is turned on, thereby achieving image refresh or image retention.

In an embodiment of the present disclosure, by controlling the timing point of the potential change of the fifth node N5 using the potential of the first node N1 and the level change of the reset signal Trst, and controlling the timing point of the potential change of the third node N3 using the potential of the fifth node N5 in combination with the level change of the first control signal CKo1 and the potential change of the second node N2, when the first input signal INPUT1 is a multi-pulse signal, the output terminal OUT may be controlled to output an output signal OUT with multiple pulses, thus achieving a partial refresh of the display panel using the multi-pulse signal.

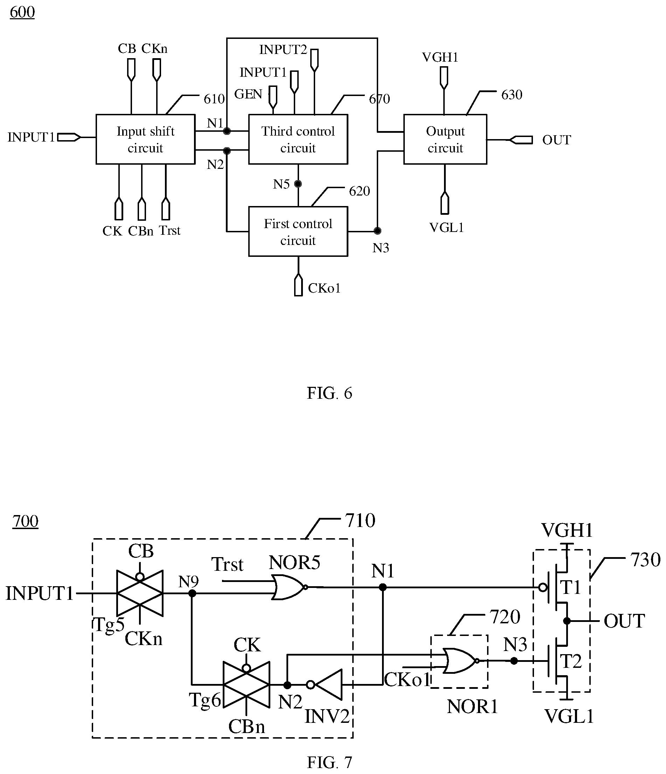

FIG. 6 shows a schematic structural diagram of a shift register according to another embodiment of the present disclosure.

As shown in FIG. 6, a shift register 600 includes an input shift circuit 610, a first control circuit 620, an output circuit 630, and a fifth control circuit 670.

The input shift circuit 610, the first control circuit 620 and the output circuit 630 are respectively similar to the input shift circuit 210, the first control circuit 220 and the output circuit 230 described above. For conciseness, details will not be repeated here..

In an embodiment of the present disclosure, the fifth control circuit 670 is electrically connected to the first node N1, the second node N2, the enable terminal GEN, the fifth node N5, the first input terminal INPUT1, and the second input terminal INPUT2. The fifth control circuit 670 may control the potential of the fifth node N5 using the potential of the first node N1, the potential of the second node N2, the first input signal INPUT1, a second input signal INPUT2 from the second input terminal INPUT2, and an enable signal GEN from the enable terminal GEN.

In an embodiment of the present disclosure, the second input terminal INPUT2 is electrically connected to the first node of a previous-stage shift register in the cascade. The potential of the first node N1, the potential of the second node N2, the first input signal INPUT1 and the second input signal INPUT2 may be used to control whether the enable terminal GEN and the fifth node N5 are in a connected state or a disconnected state. When the potential of the first node N1, the potential of the second node N2, the first input signal INPUT1 and the second input signal INPUT2 are used to control the enable terminal GEN and the fifth node N5 to be in a connected state, the fifth control circuit 670 writes the enable signal GEN to the fifth node N5. The enable signal GEN controls the potential of the third node N3 by controlling the potential of the fifth node N5. Based on the potential of the third node N3, the output terminal OUT may be controlled to output a high-level signal or a low-level signal to control whether the transistor in the pixel circuit is turned on, thereby achieving image refresh or image retention.

In an embodiment of the present disclosure, the first control circuit 520 may control the potential of the third node N3 based on the level of three signals, as shown in FIG. 5. The first control circuit 520 may also control the potential of the third node N3 based solely on the level of two signals. For a control process of the first control circuit 520 over the potential of the third node N3, reference may be made to the control process of the first control circuit 420. For conciseness, details will not be repeated here.

In an embodiment of the present disclosure, by controlling the timing point of the level change of the fifth node N5 using the level changes of the potential of the first node N1, the potential of the second node N2, the first input signal INPUT1 and the second input signal INPUT2, and controlling the timing point of the potential change of the third node N3 using the level change of the fifth node N5 in combination with the level change of the first control signal CKo1 and the potential change of the second node N2, when the first input signal INPUT1 is a multi-width single-pulse signal, the output terminal OUT may be controlled to output a multi-width single-pulse output signal, thereby achieving partial refresh of the display panel using the multi-width single-pulse signal. A duration of an active level of a multi-width single-pulse output signal is longer than that of a single-width single-pulse output signal, and the duration of the active level of a single-width single-pulse output signal may be affected by a pulse width of a clock signal.

FIG. 7 shows a schematic structural diagram of a shift register according to another embodiment of the present disclosure, in which a logic circuit diagram of the shift register in FIG. 2 is shown.

As shown in FIG. 7, the shift register 700 includes an input shift circuit 710, a first control circuit 720, and an output circuit 730.

In an embodiment of the present disclosure, the input shift circuit 710 includes a fifth transmission gate Tg5, a sixth transmission gate Tg6, a fifth NOR gate NOR5, and a second inverter INV2.

The fifth transmission gate Tg5 has a first control terminal electrically connected to the first clock terminal CB, a second control terminal electrically connected to the second clock terminal CKn, an input terminal electrically connected to the first input terminal INPUT1, and an output terminal electrically connected to a ninth node N9. The sixth transmission gate Tg6 has a first control terminal CKo1 electrically connected to the third clock terminal CK, a second control terminal electrically connected to the fourth clock terminal CBn, an input terminal electrically connected to the ninth node N9, and an output terminal electrically connected to the second node N2. The fifth NOR gate NOR5 has a first input terminal electrically connected to the reset terminal Trst, a second input terminal electrically connected to the ninth node N9, and an output terminal electrically connected to the first node N1. The second inverter INV2 has an input terminal electrically connected to the first node N1 and an output terminal electrically connected to the second node N2.

In an embodiment of the present disclosure, the first clock signal CB and the second clock signal CKn may control the fifth transmission gate Tg5 to be in an on state or an off state. When the fifth transmission gate Tg5 is in an on state, the first input signal INPUT1 is written to the ninth node N9. When the fifth transmission gate Tg5 is in an off state, the potential of the ninth node N9 remains as the potential of the previous phase.

In an embodiment of the present disclosure, the fifth NOR gate NOR5 performs a NOR operation on the potential of the ninth node N9 and the level of the reset signal Trst. For example, a high potential may be represented as a digital signal "1", and a low potential may be represented as a digital signal "0". When at least one of the potential of the ninth node N9 and the reset signal Trst is at a high level, the fifth NOR gate NOR5 controls the potential of the first node N1 to be at a low level. When both the potential of the ninth node N9 and the reset signal Trst are at low level, the fifth NOR gate NOR5 controls the potential of the first node N1 to be at a high level.

In an embodiment of the present disclosure, the second inverter INV2 performs a NOT operation on the potential of the first node N1. When the first node N1 is at a high level, the second inverter INV2 controls the potential of the second node N2 to be at a low level. When the first node N1 is at a low level, the second inverter INV2 controls the potential of the second node N2 to be at a high level.

In an embodiment of the present disclosure, the third clock signal CK and the fourth clock signal CBn may control the sixth transmission gate Tg6 to be in an on state or an off state. When the sixth transmission gate Tg6 is in an on state, the potential of the second node N2 is written to the ninth node N9.

When transmitting signals using a transmission gate, it is possible to prevent a voltage drop during transmission based on low on- resistance of the transmission gate, thereby maintaining stability during voltage transmission.

In an embodiment of the present disclosure, the first control circuit 720 includes a first NOR gate NOR1. The first NOR gate NOR1 has a first input terminal electrically connected to the second node N2, a second input terminal electrically connected to the first control terminal CKo1, and an output terminal electrically connected to the third node N3.

In an embodiment of the present disclosure, the first NOR gate NOR1 performs a NOR operation on the potential of the second node N2 and the level of the first control signal CKo1. When at least one of the potential of the second node N2 and the level of the first control signal CKo1 is at a high level, the first NOR gate NOR1 controls the potential of the third node N3 to be at a low level. When both the potential of the second node N2 and the level of the first control signal CKo1 are at low level, the first NOR gate NOR1 controls the potential of the third node N3 to be at a high level.

In an embodiment of the present disclosure, the output circuit 730 includes a first transistor T1 and a second transistor T2. The first transistor T1 is a PMOS transistor, and the second transistor T2 is an NMOS transistor. When the potential of the first node N1 is at a low level, the first transistor T1 is turned on, and the first power supply voltage VGH1 is provided to the output terminal OUT. When the potential of the third node N3 is at a high level, the second transistor T2 is turned on, and the second power supply voltage VGL1 is provided to the output terminal OUT.

In an embodiment of the present disclosure, through the potential changes of the first node N1 and the third node N3, it is possible to first turn off the first transistor T1 and then turn on the second transistor T2, and first turn off the second transistor T2 and then turn on the first transistor T1. This prevents simultaneous turn-on of the first transistor T1 and the second transistor T2 in the output circuit 730, thereby avoiding an occurrence of instantaneous large current between the first power supply voltage VGH1 and the second power supply voltage VGL1.

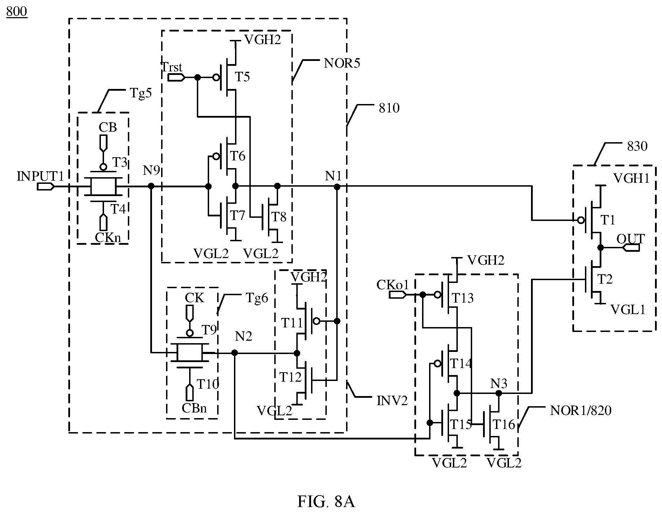

FIG. 8A shows a schematic structural diagram of a shift register according to another embodiment of the present disclosure, in which a circuit structure diagram of the shift register in FIG. 7 is shown.

As shown in FIG. 8A, a shift register 800 includes an input shift circuit 810, a first control circuit 820, and an output circuit 830.

In an embodiment of the present disclosure, the input shift circuit 810 includes a third transistor T3 to a twelfth transistor T12, the first control circuit 820 includes a thirteenth transistor T13 to a sixteenth transistor T16, and the output circuit 830 includes a first transistor T1 and a second transistor T2.

The first transistor T1 has a control electrode electrically connected to the first node N1, a first electrode electrically connected to the first power supply voltage VGH1, and a second electrode electrically connected to the output terminal OUT.

The second transistor T2 has a control electrode electrically connected to the third node N3, a first electrode electrically connected to the output terminal OUT, and a second electrode electrically connected to the second power supply voltage VGL1.

The third transistor T3 has a control electrode electrically connected to the first clock terminal CB, a first electrode electrically connected to the first input terminal INPUT1, and a second electrode electrically connected to the ninth node N9.

The fourth transistor T4 has a control electrode electrically connected to the first clock terminal CKn, a first electrode electrically connected to the first input terminal INPUT1, and a second electrode electrically connected to the ninth node N9.

The fifth transistor T5 has a control electrode electrically connected to the reset terminal Trst, a first electrode electrically connected to the power supply VGH2, and a second electrode electrically connected to a first electrode of the sixth transistor T6.

The sixth transistor T6 has a control electrode electrically connected to the ninth node N9 and a second electrode electrically connected to the first node N1.

The seventh transistor T7 has a control electrode electrically connected to the ninth node N9, a first electrode electrically connected to the first node N1, and a second electrode electrically connected to the power supply VGL2.

The eighth transistor T8 has a control electrode electrically connected to the reset terminal Trst, a first electrode electrically connected to the first node N1, and a second electrode electrically connected to the power supply VGL2.

The ninth transistor T9 has a control electrode electrically connected to the third clock terminal CK, a first electrode electrically connected to the ninth node N9, and a second electrode electrically connected to the second node N2.

The tenth transistor T10 has a control electrode electrically connected to the fourth clock terminal CBn, a first electrode electrically connected to the ninth node N9, and a second electrode electrically connected to the second node N2.

The eleventh transistor T11 has a control electrode electrically connected to the first node N1, a first electrode electrically connected to the power supply VGH2, and a second electrode electrically connected to the second node N2.

The twelfth transistor T12 has a control electrode electrically connected to the first node N1, a first electrode electrically connected to the second node N2, and a second electrode electrically connected to the power supply VGL2.

The thirteenth transistor T13 has a control electrode electrically connected to the first control terminal CKo1, a first electrode electrically connected to the power supply VGH2, and a second electrode electrically connected to a first electrode of the fourteenth transistor T14.

The fourteenth transistor T14 has a control electrode electrically connected to the second node N2 and a second electrode electrically connected to the third node N3.

The fifteenth transistor T15 has a control electrode electrically connected to the second node N2, a first electrode electrically connected to the third node N3, and a second electrode electrically connected to the power supply VGL2.

The sixteenth transistor T16 has a control electrode electrically connected to the first control terminal CKo1, a first electrode electrically connected to the third node N3, and a second electrode electrically connected to the power supply VGL2.

In an embodiment of the present disclosure, the first transistor T1, the third transistor T3, the fifth transistor T5, the sixth transistor T6, the ninth transistor T9, the eleventh transistor T11, the thirteenth transistor T13 and the fifteenth transistor T15 are P-type TFT transistors, such as thin-film transistors with an active layer made of low-temperature polycrystalline silicon (LTPS). The second transistor T2, the fourth transistor T4, the seventh transistor T7, the eighth transistor T8, the tenth transistor T10, the twelfth transistor T12, the fourteenth transistor T14 and the sixteenth transistor T16 are N-type TFT transistors, such as thin-film transistors with an active layer made of indium gallium zinc oxide (IGZO). Those skilled in the art may appreciate that in the present disclosure, the first transistor T1, the third transistor T3, the fifth transistor T5, the sixth transistor T6, the ninth transistor T9, the eleventh transistor T11, the thirteenth transistor T13 and the fifteenth transistor T15 may be N-type TFT transistors, and the second transistor T2, the fourth transistor T4, the seventh transistor T7, the eighth transistor T8, the tenth transistor T10, the twelfth transistor T12, the fourteenth transistor T14 and the sixteenth transistor T16 may be P-type TFT transistors, and it is only needed to change the level of a gate drive signal for each transistor accordingly.

In the description of embodiments of the present disclosure, the first node N1 to the ninth node N9 do not represent physically existing components, but rather represent junction points of relevant circuit connections in the circuit diagram.

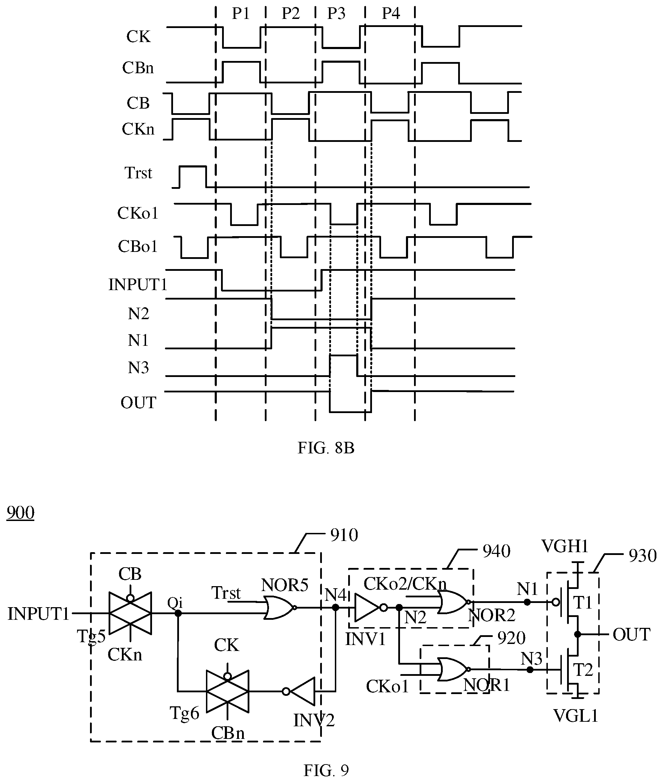

FIG. 8B shows a signal timing diagram of a shift register according to an embodiment of the present disclosure.

An operation process of the shift register 800 provided in an embodiment of the present disclosure will be described below with reference to the signal timing diagram shown in FIG. 8B by taking the structure of the shift register 800 shown in FIG. 8A as an example. The operation process of the shift register 800 is divided into four time periods. The first control signal CKo1 is provided to the shift register 800, and the signal CBo1 is provided to the first control signal terminal of a next-stage shift register cascaded with the shift register 800.

In a first time period P1, the first clock signal CB is at a high level, the second clock signal CKn is at a low level, the third clock signal CK is at a low level, and the fourth clock signal CBn is at a high level. The reset signal Trst is at a low level, the first control signal CKo1 is at a low level, and the first input signal INPUT1 is at a low level.

The third transistor T3 and the fourth transistor T4 are turned off, the ninth transistor T9 and the tenth transistor T10 are turned on, and the potential of the ninth node N9 remains at the high level of the previous phase. The fifth transistor T5 and the seventh transistor T7 are turned on, the sixth transistor T6 and the eighth transistor T8 are turned off, the power supply voltage VGL2 is written to the first node N1, and the potential of the first node N1 is at a low level.

The eleventh transistor T11 is turned on, the twelfth transistor T12 is turned off, the power supply voltage VGH2 is written to the second node N2, and the potential of the second node N2 is at a high level. The thirteenth transistor T13 and the fifteenth transistor T15 are turned on, the fourteenth transistor T14 and the sixteenth transistor T16 are turned off, the power supply voltage VGL2 is written to the third node N3, and the potential of the third node N3 is at a low level.

The first transistor T1 is turned on, the second transistor T2 is turned off, the first power supply voltage VGH1 is provided to the output terminal OUT through the first transistor T1, and the output signal OUT from the output terminal OUT is at a high level.

In a second time period P2, the first clock signal CB is at a low level, the second clock signal CKn is at a high level, the third clock signal CK is at a high level, and the fourth clock signal CBn is at a low level. The reset signal Trst is at a low level, the first control signal CKo1 is at a high level, and the first input signal INPUT1 is at a low level.

The third transistor T3 and the fourth transistor T4 are turned on, the ninth transistor T9 and the tenth transistor T10 are turned off, the first input signal INPUT1 is written to the ninth node N9, and the potential of the ninth node N9 is pulled down to a low level. The fifth transistor T5 and the sixth transistor T6 are turned on, the seventh transistor T7 and the eighth transistor T8 are turned off, the power supply voltage VGH2 is written to the first node N1, and the potential of the first node N1 is at a high level.

The eleventh transistor T11 is turned off, the twelfth transistor T12 is turned on, the power supply voltage VGL2 is written to the second node N2, and the potential of the second node N2 is at a low level. The thirteenth transistor T13 and the fifteenth transistor T15 are turned off, the fourteenth transistor T14 and the sixteenth transistor T16 are turned on, the power supply voltage VGL2 is written to the third node N3, and the potential of the third node N3 is at a low level.

The first transistor T1 and the second transistor T2 are turned off, and the output signal OUT from the output terminal OUT remains at a high level.

In a third time period P3, the first clock signal CB is at a high level, the second clock signal CKn is at a low level, the third clock signal CK is at a low level, and the fourth clock signal CBn is at a high level. The reset signal Trst is at a low level, the first control signal CKo1 is at a low level, and the first input signal INPUT1 is at a high level.

The third transistor T3 and the fourth transistor T4 are turned off, the ninth transistor T9 and the tenth transistor T10 are turned on, and the potential of the ninth node N9 remains at the low level of the previous phase. The fifth transistor T5 and the sixth transistor T6 are turned on, the seventh transistor T7 and the eighth transistor T8 are turned off, the power supply voltage VGH2 is written to the first node N1, and the potential of the first node N1 is at a high level.

The eleventh transistor T11 is turned off, the twelfth transistor T12 is turned on, the power supply voltage VGL2 is written to the second node N2, and the potential of the second node N2 is at a low level. The thirteenth transistor T13 and the fourteenth transistor T14 are turned on, the fifteenth transistor T15 and the sixteenth transistor T16 are turned on, the power supply voltage VGH2 is written to the third node N3, and the potential of the third node N3 is at a high level.

The first transistor T1 is turned off, the second transistor T2 is turned on, the second power supply voltage VGL1 is provided to the output terminal OUT through the second transistor T2, and the output signal OUT from the output terminal OUT is at a low level.

In a fourth time period P4, the first clock signal CB is at a low level, the second clock signal CKn is at a high level, the third clock signal CK is at a high level, and the fourth clock signal CBn is at a low level. The reset signal Trst is at a low level, the first control signal CKo1 is at a high level, and the first input signal INPUT1 is at a high level.

The third transistor T3 and the fourth transistor T4 are turned on, the ninth transistor T9 and the tenth transistor T10 are turned off, the first input signal INPUT1 is written to the ninth node N9, and the potential of the ninth node N9 is at a high level. The fifth transistor T5 and the seventh transistor T7 are turned on, the sixth transistor T6 and the eighth transistor T8 are turned off, the power supply voltage VGL2 is written to the first node N1, and the potential of the first node N1 is at a low level.

The eleventh transistor T11 is turned on, the twelfth transistor T12 is turned off, the power supply voltage VGH2 is written to the second node N2, and the potential of the second node N2 is at a high level. The thirteenth transistor T13 and the fifteenth transistor T15 are turned on, the fourteenth transistor T14 and the sixteenth transistor T16 are turned off, the power supply voltage VGL2 is written to the third node N3, and the potential of the third node N3 is at a low level.

The first transistor T1 is turned on, the second transistor T2 is turned off, the first power supply voltage VGH1 is provided to the output terminal OUT through the first transistor T1, and the output signal OUT from the output terminal OUT is at a high level.

In an embodiment of the present disclosure, the output signal OUT from the output terminal OUT may be used to drive a PMOS transistor in the pixel circuit.

In an embodiment of the present disclosure, prior to the first time period P1, the reset signal Trst is at a high level. The first input signal INPUT1 is written to the ninth node N9, and the potential of the ninth node N9 is at a high level. The fifth transistor T5 and the sixth transistor T6 are turned off, the seventh transistor T7 and the eighth transistor T8 are turned on, the power supply voltage VGL2 is written to the first node N1, and the potential of the first node N1 is at a low level. The first transistor T1 is turned on, the first power supply voltage VGH1 is provided to the output terminal OUT through the first transistor T1 to reset the potential of the output terminal OUT, and the potential of the output terminal is at a high level. In an embodiment of the present disclosure, in the second time period P2, when the first clock signal CB transitions from a high level to a low level and the second clock signal CKn transitions from a low level to a high level, the third transistor T3 and the fourth transistor T4 are turned on, and the first input signal INPUT1 is written to the ninth node N9. Since the potential of the reset signal Trst remains at a low level, when the potential of the ninth node N9 transitions to a low level, the potential of the first node N1 simultaneously transitions to a high level, then the first transistor T1 switches from an on state to an off state, the potential of the third node N3 remains at a low level, and the second transistor T2 is turned off.

In the third time period P3, when the first control signal CKo1 transitions from a high level to a low level, the thirteenth transistor T13 is turned on, and the sixteenth transistor T16 is turned off. Since the potential of the second node N2 remains at a low level, when the first control signal CKo1 transitions from a high level to a low level, the power supply voltage VGH1 is written to the third node N3 through the thirteenth transistor T13 and the fourteenth transistor T14, and the potential of the third node N3 simultaneously transitions to a high level, then the second transistor T2 switches from an off state to an on state. Because the first clock signal CB transitions from a low level to a high level in the second time period P2 and remains at a low level in the time period P3, the level transition of the first input signal INPUT1 does not affect the potential change of the first node N1, and the first transistor T1 remains in an off state.

In the third time period P3, when the first control signal CKo1 transitions from a low level to a high level, the thirteenth transistor T13 is turned off and the sixteenth transistor T16 is turned on. Since the potential of the second node N2 remains at a low level, when the first control signal CKo1 transitions from a low level to a high level, the power supply voltage VGL1 is written to the third node N3 through the sixteenth transistor T16, and the potential of the third node N3 simultaneously transitions to a low level, then the second transistor T2 switches from an on state to an off state.

In the fourth time period P4, when the first clock signal CB transitions from a high level to a low level and the second clock signal CKn transitions from a low level to a high level, the third transistor T3 and the fourth transistor T4 are turned on, and the first input signal INPUT1 is written to the ninth node N9. Since the potential of the reset signal Trst remains at a low level, when the potential of the ninth node N9 transitions to a high level, the potential of the first node N1 simultaneously transitions to a low level, then the first transistor T1 switches from an off state to an on state, the potential of the third node N3 remains at a low level, and the second transistor T2 is turned off.

In an embodiment of the present disclosure, in the second time period P2 and the third time period P3, based on the timing point of the level transition of the first clock signal CB and the second clock signal CKn, the first transistor T1 is controlled to switch from an on state to an off state and remains in the off state. In the third time period P3, based on the timing point of the level transition of the first control signal CKo1, the second transistor T2 is controlled to first switch from an off state to an on state, then switch from an on state to an off state, and remains in the off state until the fourth time period P4. In the fourth time period P4, based on the timing point of the level transition of the first clock signal CB and the second clock signal CKn, the first transistor T1 is controlled to switch from an off state to an on state.

When the second transistor T2 is in an off state, it is possible to first control the first transistor T1 to be in an off state and then control the second transistor T2 to switch to an on state through the timing point of the level transition of the first control signal CKo1, the first clock signal CB and the second clock signal CKn. After the output terminal OUT outputs a low-level signal, it is possible to first control the second transistor T2 to switch to an off state and then control the first transistor T1 to switch to an on state through the timing point of the level transition of the first control signal CKo1, the first clock signal CB and the second clock signal CKn. This ensures that the first transistor T1 and the second transistor T2 are not simultaneously in the on state, thereby preventing an occurrence of instantaneous large current between the first power supply VGH1 and the second power supply VGL1 and avoiding leakage current in the circuit.

By separating the node for controlling the on/off state of the first transistor T1 and the second transistor T2 into the first node N1 and the third node N3 and then separately controlling the potential change of the first node N1 and the potential change of the third node N3 using the first control signal CKo1, the first clock signal CB and the second clock signal CKn, it is possible to separately control the first transistor T1 and the second transistor T2. By controlling the timing point at which the first transistor T1 and the second transistor T2 are turned on or turned off through the timing point of the level transition of the first control signal CKo1, the first clock signal CB and the second clock signal CKn, it is possible to prevent the first transistor T1 and the second transistor T2 from being simultaneously in the on state, thereby avoiding an occurrence of leakage current in the circuit, reducing the power consumption of the circuit, and improving the driving capability.

In an embodiment of the present disclosure, the fourth clock signal CBn may have the same timing change as the first clock signal CB, and the third clock signal CK may have the same timing change as the second clock signal CKn. For example, for the timing change of the fourth clock signal CBn, reference may be made to the timing change of the first clock signal CB shown in FIG. 8B, and for the timing change of the third clock signal CK, reference may be made to the timing change of the second clock signal CKn shown in FIG. 8B. For example, the control electrode of the ninth transistor T9 may be electrically connected to the second clock terminal CKn, and the control electrode of the tenth transistor T10 may be electrically connected to the first clock terminal CB. This may also prevent the first transistor T1 and the second transistor T2 from being simultaneously in the on state, thereby avoiding an occurrence of leakage current in the circuit, reducing the power consumption of the circuit, and improving the driving capability. In addition, the number of signal lines in the circuit may be reduced, which is beneficial for a narrow bezel of the display device.

In an embodiment of the present disclosure, the first power supply voltage VGH1 provided by the first power supply VGH1 may be the same as the power supply voltage VGH2 provided by the power supply VGH2, and the second power supply voltage VGL1 provided by the second power supply VGL1 may be the same as the power supply voltage VGL2 provided by the power supply VGL2. For example, the first electrode of the fifth transistor T5, the first electrode of the eleventh transistor T11, the first electrode of the thirteenth transistor T13 and the first electrode of the first transistor T1 may all be electrically connected to the first power supply VGH1. The second electrode of the seventh transistor T7, the second electrode of the eighth transistor T8, the second electrode of the twelfth transistor T12, the second electrode of the fifteenth transistor T15, the second electrode of the sixteenth transistor T16 and the second electrode of the second transistor T2 may all be electrically connected to the second power supply VGL1. By simplifying the power supply structure in the circuit, the number of power supply lines in the circuit may be reduced, which is beneficial for a narrow bezel of the display device.

FIG. 9 shows a schematic structural diagram of a shift register according to another embodiment of the present disclosure, in which a logic circuit diagram of the shift register in FIG. 3 is shown.

As shown in FIG. 9, a shift register 900 includes an input shift circuit 910, a first control circuit 920, an output circuit 930, and a second control circuit 940.

In an embodiment of the present disclosure, the input shift circuit 910, the first control circuit 920 and the output circuit 930 are similar in structure to the input shift circuit 710, the first control circuit 720 and the output circuit 730 described above. For conciseness, details will not be repeated here.

It should be noted that the potential change of the second node N2 shown in FIG. 9 is consistent with that of the second node N2 shown in FIG. 7. The second node N2 shown in FIG. 9 may also be the output terminal of the second inverter INV2.

In an embodiment of the present disclosure, the second control circuit 940 includes a first inverter INV1 and a second NOR gate NOR2. The first inverter INV1 has an input terminal electrically connected to the fourth node N4 and an output terminal electrically connected to the second node N2.

The second NOR gate NOR2 has a first input terminal electrically connected to the second control terminal CKo2 or the second clock terminal CKn, a second input terminal electrically connected to the second node N2, and an output terminal electrically connected to the first node N1.

In an embodiment of the present disclosure, the fifth NOR gate NOR5 performs a NOR operation on the level of the reset signal Trst and the level of the ninth node N9 to control the potential of the fourth node N4.

In an embodiment of the present disclosure, the first inverter INV1 performs a NOT operation on the potential of the fourth node N4. When the fourth node N4 is at a high level, the first inverter INV1 controls the potential of the second node N2 to be at a low level. When the fourth node N4 is at a low level, the first inverter INV1 controls the potential of the second node N2 to be at a high level.

In an embodiment of the present disclosure, the second NOR gate NOR2 performs a NOR operation on the potential of the second node N2 and the level of the second control signal CKo2. When at least one of the potential of the second node N2 and the level of the second control signal CKo2 is at a high level, the second NOR gate NOR2 controls the potential of the first node N1 to be at a low level. When both the potential of the second node N2 and the second control signal CKo2 are at low level, the second NOR gate NOR2 controls the potential of the first node N1 to be at a high level.

In an embodiment of the present disclosure, the second NOR gate NOR2 may further perform a NOR operation on the potential of the second node N2 and the level of the second clock signal CKn. When at least one of the potential of the second node N2 and the level of the second clock signal CKn is at a high level, the second NOR gate NOR2 controls the potential of the first node N1 to be at a low level. When both the potential of the second node N2 and the level of the second clock signal CKn are at low level, the second NOR gate NOR2 controls the potential of the first node N1 to be at a high level.

In an embodiment of the present disclosure, by controlling the potential of the first node N1 using the second control signal CKo2 or the second clock signal CKn jointly with the second node N2, when the first input signal INPUT1 is a multi-pulse signal, the output terminal OUT may be controlled to output a multi-pulse output signal OUT, thereby driving the transistor in the pixel circuit using a multi-pulse signal. By multiplexing the second clock signal CKn, the number of signal lines in the circuit may be reduced, which is beneficial for a narrow bezel of the display device and reducing the power consumption of the shift register.

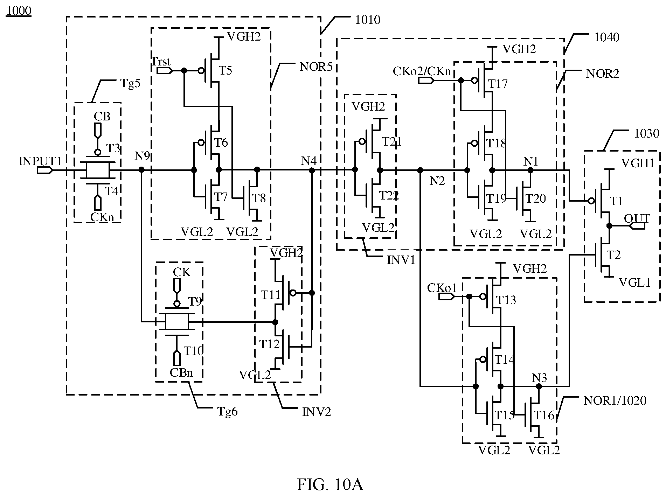

FIG. 10A shows a schematic structural diagram of a shift register according to another embodiment of the present disclosure, in which a circuit structure diagram of the shift register in FIG. 9 is shown.

As shown in FIG. 10A, a shift register 1000 includes an input shift circuit 1010, a first control circuit 1020, an output circuit 1030, and a second control circuit 1040.

In an embodiment of the present disclosure, the input shift circuit 810 includes a third transistor T3 to a twelfth transistor T12, the first control circuit 820 includes a thirteenth transistor T13 to a sixteenth transistor T16, the output circuit 830 includes a first transistor T1 and a second transistor T2, and the second control circuit 1040 includes a seventeenth transistor T17 to a twenty-second transistor T22.

The seventeenth transistor T17 has a control electrode electrically connected to the second control terminal CKo2 or the second clock terminal CKn, a first electrode electrically connected to the power supply VGH2, and a second electrode electrically connected to a first electrode of the eighteenth transistor T18.

The eighteenth transistor T18 has a control electrode electrically connected to the second node N2, and a second electrode electrically connected to the first node N1.

The nineteenth transistor T19 has a control electrode electrically connected to the second node N2, a first electrode electrically connected to the first node N1, and a second electrode electrically connected to the power supply VGL2.

The twentieth transistor T20 has a control electrode electrically connected to the second control terminal CKo2 or the second clock terminal CKn, a first electrode electrically connected to the first node N1, and a second electrode electrically connected to the power supply VGL2.

The twenty-first transistor T21 has a control electrode electrically connected to the fourth node N4, a first electrode electrically connected to the power supply VGH2, and a second electrode electrically connected to the second node N2.

The twenty-second transistor T22 has a control electrode electrically connected to the fourth node N4, a first electrode electrically connected to the second node N2, and a second electrode electrically connected to the power supply VGL2.

The second electrode of the sixth transistor, the first electrode of the seventh transistor T7, the first electrode of the eighth transistor T8, the control electrode of the eleventh transistor T11 and the control electrode of the twelfth transistor T12 are electrically connected to the fourth node N4. The second electrode of the ninth transistor T9 and the second electrode of the tenth transistor T10 are electrically connected to the second electrode of the eleventh transistor T11.

For the connections of the remaining transistors in the shift register 1000, reference may be made to the connections shown in FIG. 8A. For conciseness, details will not be repeated here.

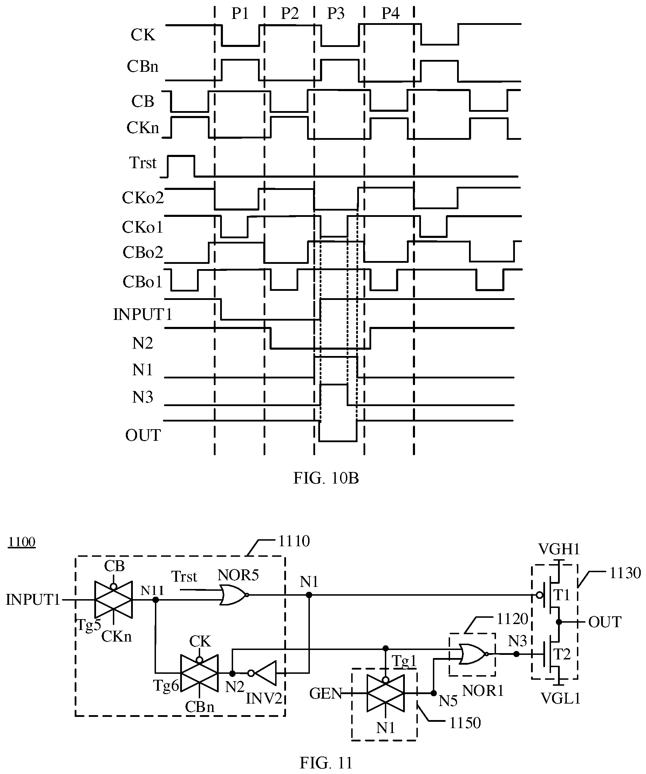

FIG. 10B shows a signal timing diagram of a shift register according to an embodiment of the present disclosure.

An operation process of the shift register 1000 provided in an embodiment of the present disclosure will be described below with reference to the signal timing diagram shown in FIG. 10B by taking the structure of the shift register 1000 shown in FIG. 10A as an example. The operation process of the shift register 1000 is divided into four time periods. The first control signal CKo1 and the second control signal CKo2 are provided to the shift register 1000, and the signal CBo1 and the signal CBo2 are respectively provided to the first control signal terminal and the second control signal terminal of a next-stage shift register cascaded with the shift register 1000.

In a first time period P1, the first clock signal CB is at a high level, the second clock signal CKn is at a low level, the third clock signal CK is at a low level, and the fourth clock signal CBn is at a high level. The reset signal Trst is at a low level, the first control signal CKo1 is at a low level, the first input signal INPUT1 is at a low level, and the second control signal CKo2 is at a low level.

The third transistor T3 and the fourth transistor T4 are turned off, the ninth transistor T9 and the tenth transistor T10 are turned on, and the potential of the ninth node N9 remains at the high level of the previous phase. The fifth transistor T5 and the seventh transistor T7 are turned on, the sixth transistor T6 and the eighth transistor T8 are turned off, the power supply voltage VGL2 is written to the fourth node N4, and the potential of the fourth node N4 is at a low level.

The twenty-first transistor T21 is turned on, the twenty-second transistor T22 is turned off, the power supply voltage VGH2 is written to the second node N2, and the potential of the second node N2 is at a high level. The eleventh transistor T11 is turned on, the twelfth transistor T12 is turned off, the power supply voltage VGH2 is written to the ninth node N9 through the eleventh transistor T11, the ninth transistor T9 and the tenth transistor T10, and the potential of the ninth node N9 stably remains at a high level.

The seventeenth transistor T17 and the nineteenth transistor T19 are turned on, the eighteenth transistor T18 and the twentieth transistor T20 are turned off, the power supply voltage VGL2 is written to the first node N1, and the potential of the first node N1 is at a low level.

The thirteenth transistor T13 and the fifteenth transistor T15 are turned on, the fourteenth transistor T14 and the sixteenth transistor T16 are turned off, the power supply voltage VGL2 is written to the third node N3, andthe potential of the third node N3 is at a low level.

The first transistor T1 is turned on, the second transistor T2 is turned off, the first power supply voltage VGH1 is provided to the output terminal OUT through the first transistor T1, and the output signal OUT from the output terminal OUT is at a high level.

In a second time period P2, the first clock signal CB is at a low level, the second clock signal CKn is at a high level, the third clock signal CK is at a high level, and the fourth clock signal CBn is at a low level. The reset signal Trst is at a low level, the first control signal CKo1 is at a high level, the first input signal INPUT1 is at a low level, and the second control signal CKo2 is at a high level.

The first input signal INPUT1 is written to the ninth node N9, and the potential of the ninth node N9 is at a low level. The power supply voltage VGH2 is written to the fourth node N4, and the potential of the fourth node N4 is at a high level.

The twenty-first transistor T21 is turned off, the twenty-second transistor T22 is turned on, the power supply voltage VGL2 is written to the second node N2, and the potential of the second node N2 is at a low level. The eighteenth transistor T18 and the twentieth transistor T20 are turned on, the nineteenth transistor T19 and the seventeenth transistor T17 are turned off, the power supply voltage VGL2 is written to the first node N1, and the potential of the first node N1 is at a low level.

The thirteenth transistor T13 and the fifteenth transistor T15 are turned off, the fourteenth transistor T14 and the sixteenth transistor T16 are turned on, the power supply voltage VGL2 is written to the third node N3, and the potential of the third node N3 is at a low level.

The first transistor T1 is turned on, the second transistor T2 is turned off, the first power supply voltage VGH1 is provided to the output terminal OUT through the first transistor T1, and the output signal OUT from the output terminal OUT is at a high level.

In a third time period P3, the first clock signal CB is at a high level, the second clock signal CKn is at a low level, the third clock signal CK is at a low level, and the fourth clock signal CBn is at a high level. The reset signal Trst is at a low level, the first control signal CKo1 is at a low level, the first input signal INPUT1 is at a low level, and the second control signal CKo2 is at a low level.

The third transistor T3 and the fourth transistor T4 are turned off, the ninth transistor T9 and the tenth transistor T10 are turned on, and the potential of the ninth node N9 remains at the low level of the previous phase. The fifth transistor T5 and the sixth transistor T6 are turned on, the seventh transistor T7 and the eighth transistor T8 are turned off, the power supply voltage VGH2 is written to the fourth node N4, and the potential of the fourth node N4 is at a high level.

The twenty-first transistor T21 is turned off, the twenty-second transistor T22 is turned on, the power supply voltage VGL2 is written to the second node N2, and the potential of the second node N2 is at a low level. The eighteenth transistor T18 and the seventeenth transistor T17 are turned on, the nineteenth transistor T19 and the twentieth transistor T20 are turned off, the power supply voltage VGH2 is written to the first node N1, and the potential of the first node N1 is at a high level.

The thirteenth transistor T13 and the fourteenth transistor T14 are turned on, the fifteenth transistor T15 and the sixteenth transistor T16 are turned off, the power supply voltage VGH2 is written to the third node N3, and the potential of the third node N3 is at a high level.

The first transistor T1 is turned off, the second transistor T2 is turned on, the second power supply voltage VGH2 is provided to the output terminal OUT through the second transistor T2, and the output signal OUT from the output terminal OUT is at a low level.

In a fourth time period P4, for the potential changes of the nodes and the output signal OUT from the output terminal OUT, reference may be made to the description of the fourth time period P4 in FIG. 8B. For conciseness, details will not be repeated here.

In an embodiment of the present disclosure, if the control electrode of the seventeenth transistor T17 is electrically connected to the second control terminal CKo2, then in the third time period P3, when the second control signal CKo2 transitions from a high level to a low level, the potential of the first node N1 simultaneously transitions from a low level to a high level because the potential of the second node N2 remains at a low level.

In an embodiment of the present disclosure, if the control electrode of the seventeenth transistor T17 is electrically connected to the second clock terminal CKn, then in the second time period P2, when the second clock signal CKn transitions from a high level to a low level, the potential of the first node N1 simultaneously transitions from a low level to a high level because the potential of the second node N2 remains at a low level.

When the potential of the first node N1 transitions from a low level to a high level, the potential of the third node N3 remains at a low level. At this time, when the second transistor T2 remains in an off state, the first transistor T1 switches from an on state to an off state.

In the third time period P3, when the first control signal CKo1 transitions from a high level to a low level, the potential of the third node N3 simultaneously transitions to a high level because the potential of the second node N2 remains at a low level, then the second transistor T2 switches from an off state to an on state. When the first control signal CKo1 transitions from a low level to a high level, the potential of the third node N3 simultaneously transitions to a low level, then the second transistor T2 switches from an on state to an off state. When the second control signal CKo2 transitions from a low level to a high level, the potential of the first node N1 simultaneously transitions from a high level to a low level because the potential of the second node N2 remains at a low level.

If the control electrode of the seventeenth transistor T17 is electrically connected to the second control terminal CKo2, then in the third time period P3, the first control signal CKo1 first transitions from a high level to a low level, and then the second control signal CKo2 transitions from a high level to a low level. Subsequently, the first control signal CKo1 first transitions from a low level to a high level, and then the second control signal CKo2 transitions from a low level to a high level. Accordingly, in the third time period P3, the first transistor T1 is first controlled to switch from an on state to an off state based on the timing point of the level transition of the second control signal CKo2, and then the second transistor T2 is controlled to switch from an off state to an on state based on the timing point of the level transition of the first control signal CKo1. Subsequently, the second transistor T2 is first controlled to switch from an on state to an off state based on the timing point of the level transition of the first control signal CKo1, and then the first transistor T1 is controlled to switch from an off state to an on state based on the timing point of the level transition of the second control signal CKo2.

If the control electrode of the seventeenth transistor T17 is electrically connected to the second clock terminal CKn, in the second time period P2, the first transistor T1 is controlled to switch from an on state to an off state based on the timing point of the level transition of the second clock signal CKn, and in the third time period P3, the second transistor T2 is controlled to switch from an off state to an on state based on the timing point of the level transition of the first control signal CKo1 and is controlled to switch from an on state to an off state based on the timing point of the level transition of the first control signal CKo1. Subsequently, in the fourth time period P4, the first transistor T1 is controlled to switch from an off state to an on state based on the timing point of the level transition of the second clock signal CKn.

When the second transistor T2 is in an off state, it is possible to first control the first transistor T1 to be in an off state and then control the second transistor T2 to switch to an on state based on the timing point of the level transition of the first control signal CKo1 and the second control signal CKo2, or based on the timing point of the level transition of the first control signal CKo1 and the second clock signal CKn. After the output terminal OUT outputs a low-level signal, it is possible to first control the second transistor T2 to switch to an off state and then control the first transistor T1 to switch to an on state based on the timing point of the level transition of the first control signal CKo1 and the second control signal CKo2, or based on the timing point of the level transition of the first control signal CKo1 and the second clock signal CKn. This prevents the first transistor T1 and the second transistor T2 being simultaneously in the on state, thereby avoiding an occurrence of instantaneous large current between the first power supply VGH1 and the second power supply VGL1 and avoiding leakage current in the circuit.

In an embodiment of the present disclosure, when the first input signal INPUT1 is a multi-pulse signal, the second control signal CKo2 or the second clock signal CKn may control the output terminal OUT to output a multi-pulse output signal OUT.

FIG. 11 shows a schematic structural diagram of a shift register according to another embodiment of the present disclosure, in which a logic circuit diagram of the shift register in FIG. 4 is shown.

As shown in FIG. 11, a shift register 1100 includes an input shift circuit 1110, a first control circuit 1120, an output circuit 1130, and a third control circuit 1150.

In an embodiment of the present disclosure, the input shift circuit 1110, the first control circuit 1120 and the output circuit 1130 are similar in structure to the input shift circuit 710, the first control circuit 720 and the output circuit 730 described above. For conciseness, details will not be repeated here.

In an embodiment of the present disclosure, the third control circuit 1150 includes a first transmission gate Tg1. The first transmission gate Tg1 has a first control terminal electrically connected to the first node N1, a second control terminal electrically connected to the second node N2, an input terminal electrically connected to the enable terminal GEN, and an output terminal electrically connected to the fifth node N5.

In an embodiment of the present disclosure, the potential of the first node N1 and the potential of the second node N2 may be used to control whether the first transmission gate Tg1 is in an on state or an off state. When the first transmission gate Tg1 is in an on state, the enable signal GEN is written to the fifth node N5. When the first transmission gate Tg1 is in an off state, the potential of the fifth node N5 remains at the potential of the previous phase.

In an embodiment of the present disclosure, the first NOR gate NOR1 may be a two-input NOR gate or a three-input NOR gate.

In a case of a two-input NOR gate, the first input terminal of the first NOR gate NOR1 is electrically connected to the second node N2, and the second input terminal of the first NOR gate NOR1 is electrically connected to the fifth node N5.

In an embodiment of the present disclosure, the first NOR gate NOR1 performs a NOR operation on the potential of the second node N2 and the potential of the fifth node N5. When at least one of the potential of the second node N2 and the potential of the fifth node N5 is at a high level, the first NOR gate NOR1 controls the potential of the first node N1 to be at a low level. When both the potential of the second node N2 and the potential of the fifth node N5 are at low level, the first NOR gate NOR1 controls the potential of the first node N1 to be at a high level.

In a case of a three-input NOR gate, the first input terminal of the first NOR gate NOR1 is electrically connected to the second node N2, the second input terminal of the first NOR gate NOR1 is electrically connected to the first control terminal CKo1, the third input terminal of the first NOR gate NOR1 is electrically connected to the fifth node N5, and the output terminal of the first NOR gate NOR1 is electrically connected to the third node N3 (reference may be made to the connections shown in FIG. 4).

In an embodiment of the present disclosure, the first NOR gate NOR1 performs a NOR operation on the potential of the second node N2, the potential of the fifth node N5, and the level of the first control signal CKo1. When at least one of the potential of the second node N2, the potential of the fifth node N5, and the level of the first control signal CKo1 is at a high level, the first NOR gate NOR1 controls the potential of the first node N1 to be at a low level. When the potential of the second node N2, the potential of the fifth node N5, and the level of the first control signal CKo1 are all at low level, the first NOR gate NOR1 controls the potential of the first node N1 to be at a high level.

For example, the output signal OUT from the output terminal OUT is used to drive a PMOS transistor in the pixel circuit. The enable signal GEN controls the potential of the third node N3 by controlling the potential of the fifth node N5. By controlling the potential of the third node N3, it is possible to control whether the output terminal OUT outputs a low-level signal, thereby controlling whether the PMOS transistor is turned on and further controlling whether to refresh the pixel circuit.

For example, when the enable signal GEN is at a low level, the output signal OUT from the output terminal OUT may refresh the corresponding pixel row in the display panel at a first frequency. When the enable signal is at a high level, the output signal OUT from the output terminal OUT may refresh the corresponding pixel row in the display panel at a second frequency. When the enable signal GEN switches between a low level and a high level, the output signal OUT from the output terminal OUT may refresh the corresponding pixel row in the display panel at a third frequency. The first frequency is greater than the third frequency, and the third frequency is greater than the second frequency.

For example, the first frequency may be a high refresh rate, and the third frequency may be a low refresh rate.

For example, the first frequency may be 120Hz, and the second frequency may be 0Hz. When the enable signal GEN remains at a low level, the display image of the display panel may be refreshed 120 times per second. When the enable signal GEN remains at a high level, the display image of the display panel is not refreshed, and a static image is displayed.

For example, when the enable signal GEN switches between a high level and a low level, the display image of the display panel may be refreshed at a low refresh rate. For example, the enable signal GEN may remain at a low level in a refresh cycle and then remain at a high level in a subsequent refresh cycle. In this case, the display image of the display panel may be refreshed once every two refresh cycles, the display image may be refreshed 60 times per second, and the third frequency is 60Hz. For another example, the enable signal GEN may remain at a low level in a refresh cycle and then remain at a high level in subsequent three refresh cycles. In this case, the display image of the display panel may be refreshed once every four refresh cycles, the display image may be refreshed 30 times per second, and the third frequency is 30Hz.

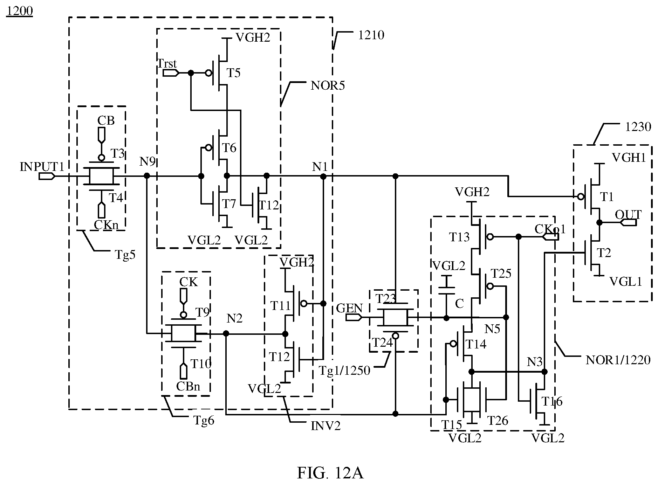

FIG. 12A shows a schematic structural diagram of a shift register according to another embodiment of the present disclosure, in which a circuit structure diagram of the shift register in FIG. 11 is shown.

As shown in FIG. 12A, a shift register 1200 includes an input shift circuit 1210, a first control circuit 1220, an output circuit 1230, and a third control circuit 1250.

In an embodiment of the present disclosure, the input shift circuit 1210 includes a third transistor T3 to a twelfth transistor T12, the first control circuit 1220 includes a thirteenth transistor T13 to a sixteenth transistor T16, a twenty-fifth transistor T25, a twenty-sixth transistor T26 and a capacitor C, the output circuit 1230 includes a first transistor T1 and a second transistor T2, and the third control circuit 1250 includes a twenty-third transistor T23 and a twenty-fourth transistor T24.

In an embodiment of the present disclosure, the first NOR gate NOR1 is a three-input NOR gate.

The twenty-third transistor T23 has a control electrode electrically connected to the first node N1, a first electrode electrically connected to the enable terminal GEN, and a second electrode electrically connected to the fifth node N5.

The twenty-fourth transistor T24 has a control electrode electrically connected to the second node N2, a first electrode electrically connected to the enable terminal GEN, and a second electrode electrically connected to the fifth node N5.

The twenty-fifth transistor T25 has a control electrode electrically connected to the fifth node N5, a first electrode electrically connected to the second electrode of the thirteenth transistor T13, and a second electrode electrically connected to the first electrode of the fourteenth transistor T14.

The twenty-sixth transistor T26 has a control electrode electrically connected to the fifth node N5, a first electrode electrically connected to the third node N3, and a second electrode electrically connected to the power supply VGL2.

The capacitor has a first terminal electrically connected to the power supply VGL2, and a second terminal electrically connected to the fifth node N5.

For the connections of the remaining transistors in the shift register 1200, reference may be made to the connections shown in FIG. 8A. For conciseness, details will not be repeated here.

Furthermore, those skilled in the art may appreciate that the capacitor may be implemented as a single capacitor or as a plurality of capacitor units connected in parallel or in series, as long as the corresponding functions may be achieved.

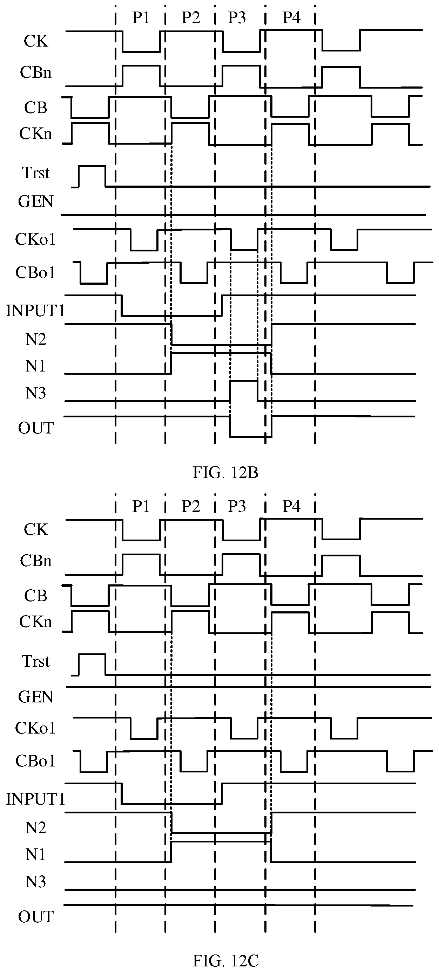

FIG. 12B and FIG. 12C show signal timing diagrams of a shift register according to an embodiment of the present disclosure.

An operation process of the shift register 1200 provided in an embodiment of the present disclosure will be described below with reference to the signal timing diagrams shown in FIG. 12B and FIG. 12C by taking the structure of the shift register 1200 shown in FIG. 12A as an example. The operation process of the shift register 1200 is divided into four time periods. The first control signal CKo1 is provided to the shift register 1200, and the signal CBo1 is provided to the first control signal terminal of a next-stage shift register cascaded with the shift register 1200.

FIG. 12B shows that the output signal OUT from the shift register 1200 may control the corresponding pixel row to be refreshed, and FIG. 12C shows that the output signal OUT from the shift register 1200 may control the corresponding pixel row not to be refreshed.

As shown in FIG. 12B, the enable signal GEN remains at a low level.

In a first time period P1, the first clock signal CB is at a high level, the second clock signal CKn is at a low level, the third clock signal CK is at a low level, and the fourth clock signal CBn is at a high level. The reset signal Trst is at a low level, the first control signal CKo1 is at a low level, and the first input signal INPUT1 is at a low level.

The potential of the first node N1 is at a low level, and the potential of the second node N2 is at a high level. The twenty-third transistor T23 and the twenty-fourth transistor T24 are turned off, the fifteenth transistor T15 is turned on, and the potential of the third node N3 is at a low level.

The first transistor T1 is turned on, the second transistor T2 is turned off, the first power supply voltage VGH1 is provided to the output terminal OUT through the first transistor T1, and the output signal OUT from the output terminal OUT is at a high level.

In a second time period P2, the first clock signal CB is at a low level, the second clock signal CKn is at a high level, the third clock signal CK is at a high level, and the fourth clock signal CBn is at a low level. The reset signal Trst is at a low level, the first control signal CKo1 is at a high level, and the first input signal INPUT1 is at a low level.

The potential of the first node N1 is at a high level, and the potential of the second node N2 is at a low level. The twenty-third transistor T23 and the twenty-fourth transistor T24 are turned on, the enable signal GEN is written to the fifth node N5, and the capacitor C is charged, so that the fifth node N5 remains at a low level.

The fourteenth transistor T14, the sixteenth transistor T16 and the twenty-fifth transistor T25 are turned on, while the fifteenth transistor T15, the thirteenth transistor T13 and the twenty-sixth transistor T26 are turned off. The power supply voltage VGL2 is written to the third node N3, and the potential of the third node N3 is at a low level.

The first transistor T1 and the second transistor T2 are turned off, and the output signal OUT from the output terminal OUT remains at a high level.

In a third time period P3, the first clock signal CB is at a high level, the second clock signal CKn is at a low level, the third clock signal CK is at a low level, and the fourth clock signal CBn is at a high level. The reset signal Trst is at a low level, the first control signal CKo1 is at a low level, and the first input signal INPUT1 is at a high level.

The potential of the first node N1 is at a high level, and the potential of the second node N2 is at a low level. The twenty-third transistor T23 and the twenty-fourth transistor T24 are turned on, and the fifth node N5 remains at a low level.

The thirteenth transistor T13, the fourteenth transistor T14 and the twenty-fifth transistor T25 are turned on, while the fifteenth transistor T15, the sixteenth transistor T16 and the twenty-sixth transistor T26 are turned off. The power supply voltage VGH2 is written to the third node N3, and the potential of the third node N3 is at a high level.

The first transistor T1 is turned off, the second transistor T2 is turned on, the second power supply voltage VGL1 is provided to the output terminal OUT through the second transistor T2, and the output signal OUT from the output terminal OUT is at a low level.

In a fourth time period P4, the first clock signal CB is at a low level, the second clock signal CKn is at a high level, the third clock signal CK is at a high level, and the fourth clock signal CBn is at a low level. The reset signal Trst is at a low level, the first control signal CKo1 is at a high level, and the first input signal INPUT1 is at a high level.

The first transistor T1 is turned on, the second transistor T2 is turned off, the first power supply voltage VGH1 is provided to the output terminal OUT through the first transistor T1, and the output signal OUT from the output terminal OUT is at a high level.

In an embodiment of the present disclosure, for the level transitions of the first node N1 and the third node N3, reference may be made to the level transitions of the first node N1 and the third node N3 described for FIG. 8B. For conciseness, details will not be repeated here.

As shown in FIG. 12C, the enable signal GEN remains at a high level.

For the potential changes of the nodes and the changes in the output signal OUT in the first time period P1, reference may be made to FIG. 12A.

In the second time period P2, the enable signal GEN is written to the fifth node N5, and the capacitor C is charged, so that the fifth node N5 remains at a high level. The fourteenth transistor T14, the sixteenth transistor T16 and the twenty-sixth transistor T26 are turned on, while the fifteenth transistor T15, the thirteenth transistor T13 and the twenty-fifth transistor T25 are turned off. The power supply voltage VGL2 is written to the third node N3, and the potential of the third node N3 is at a low level.

The first transistor T1 and the second transistor T2 are turned off, and the output signal OUT from the output terminal OUT remains at a high level.

In the third time period P3, the fifth node N5 remains at a high level. The thirteenth transistor T13, the fourteenth transistor T14 and the twenty-sixth transistor T26 are turned on, while the fifteenth transistor T15, the sixteenth transistor T16 and the twenty-fifth transistor T25 are turned off. The power supply voltage VGL2 is written to the third node N3, and the potential of the third node N3 is at a low level.

The first transistor T1 and the second transistor T2 are turned off, and the output signal OUT from the output terminal OUT remains at a high level.

For the potential changes of the nodes and the changes in the output signal OUT in the fourth time period P4, reference may be made to FIG. 12A.

In an embodiment of the present disclosure, when the enable signal GEN remains at a high level, the potential of the third node N3 always remains at a low level, so that the second transistor T2 remains in an off state, and the output terminal OUT continuously outputs the high level of the previous time period, then the pixel row electrically connected to the output terminal OUT is not refreshed.

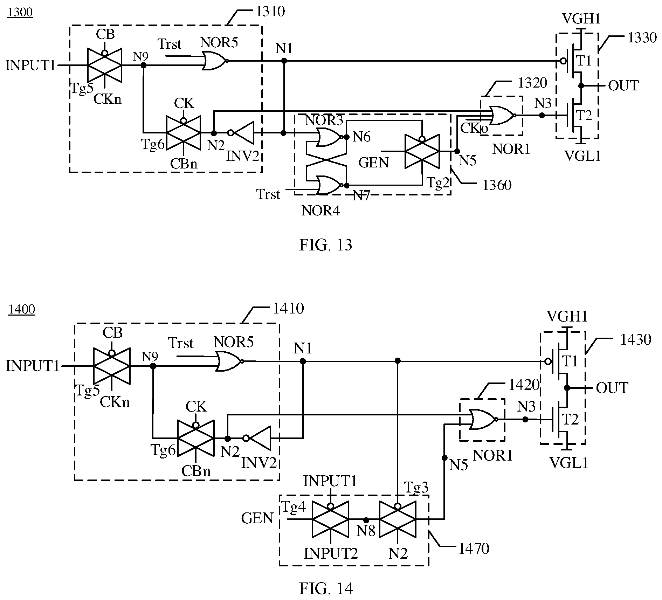

FIG. 13 shows a schematic structural diagram of a shift register according to another embodiment of the present disclosure, in which a logic circuit diagram of the shift register in FIG. 5 is shown.

As shown in FIG. 13, a shift register 1300 includes an input shift circuit 1310, a first control circuit 1320, an output circuit 1330, and a fourth control circuit 1360.

In an embodiment of the present disclosure, the input shift circuit 1310, the first control circuit 1320 and the output circuit 1330 are similar in structure to the input shift circuit 710, the first control circuit 720 and the output circuit 730 described above. For conciseness, details will not be repeated here.

In an embodiment of the present disclosure, the fourth control circuit 1360 includes a second transmission gate Tg2, a third NOR gate NOR3, and a fourth NOR gate NOR4.

The second transmission gate Tg2 has a first control terminal electrically connected to the sixth node N6, a second control terminal electrically connected to the seventh node N7, an input terminal electrically connected to the enable terminal GEN, and an output terminal electrically connected to the fifth node N5.

The third NOR gate NOR3 has a first input terminal electrically connected to the first node N1, a second input terminal electrically connected to the seventh node N7, and an output terminal electrically connected to the sixth node N6.

The fourth NOR gate NOR4 has a first input terminal electrically connected to the sixth node N6, a second input terminal electrically connected to the reset terminal Trst, and an output terminal electrically connected to the seventh node N7.

In an embodiment of the present disclosure, the third NOR gate NOR3 performs a NOR operation on the potential of the first node N1 and the potential of the seventh node N7. When at least one of the potential of the first node N1 and the potential of the seventh node N7 is at a high level, the third NOR gate NOR3 controls the potential of the sixth node N6 to be at a low level. When both the potential of the first node N1 and the potential of the seventh node N7 are at low level, the third NOR gate NOR3 controls the potential of the sixth node N6 to be at a high level.

In an embodiment of the present disclosure, the fourth NOR gate NOR4 performs a NOR operation on the level of the reset signal Trst and the potential of the sixth node N6. When at least one of the level of the reset signal Trst and the potential of the sixth node N6 is at a high level, the fourth NOR gate NOR4 controls the potential of the seventh node N7 to be at a low level. When both the level of the reset signal Trst and the potential of the sixth node N6 are at low level, the fourth NOR gate NOR4 controls the potential of the seventh node N7 to be at a high level.

In an embodiment of the present disclosure, the potential of the sixth node N6 and the potential of the seventh node N7 may be used to control whether the second transmission gate Tg2 is in an on state or an off state. When the second transmission gate Tg2 is in an on state, the enable signal GEN is written to the fifth node N5. When the second transmission gate Tg2 is in an off state, the potential of the fifth node N5 remains as the potential of the previous phase.

For example, the output signal OUT from the output terminal OUT is used to drive a PMOS transistor in the pixel circuit. The enable signal GEN controls the potential of the third node N3 by controlling the potential of the fifth node N5. By controlling the potential of the third node N3, it is possible to control whether the output terminal OUT outputs a low-level signal, thereby controlling whether the PMOS transistor is turned on and thus controlling whether to refresh the pixel circuit.

In an embodiment of the present disclosure, when the first input signal INPUT1 is a multi-pulse signal, the low level of the enable signal GEN may control the output terminal OUT to output an output signal OUT with multiple pulses, thereby achieving the refresh of the pixel circuit.

FIG. 14 shows a schematic structural diagram of a shift register according to another embodiment of the present disclosure, in which a logic circuit diagram of the shift register in FIG. 6 is shown.

As shown in FIG. 14, a shift register 1400 includes an input shift circuit 1410, a first control circuit 1420, an output circuit 1430, and a fifth control circuit 1470.

In an embodiment of the present disclosure, the input shift circuit 1410, the first control circuit 1420 and the output circuit 1430 are similar in structure to the input shift circuit 710, the first control circuit 720 and the output circuit 730 described above. For conciseness, details will not be repeated here.

In an embodiment of the present disclosure, the fifth control circuit 1470 includes a third transmission gate Tg3 and a fourth transmission gate Tg4.

The third transmission gate Tg3 has a first control terminal electrically connected to the first input terminal INPUT1, a second control terminal electrically connected to the second input terminal INPUT2, an input terminal electrically connected to the enable terminal GEN, and an output terminal electrically connected to the eighth node N8.

The fourth transmission gate Tg4 has a first control terminal electrically connected to the first node N1, a second control terminal electrically connected to the second node N2, an input terminal electrically connected to the eighth node N8, and an output terminal electrically connected to the fifth node N5.

In an embodiment of the present disclosure, the level of the first input signal INPUT1 and the level of the second input signal INPUT2 may control whether the third transmission gate Tg3 is in an on state or an off state. When the third transmission gate Tg3 is in an on state, the enable signal GEN is written to the eighth node N8. When the third transmission gate Tg3 is in an off state, the potential of the eighth node N8 remains as the potential of the previous phase.

In an embodiment of the present disclosure, the potential of the first node N1 and the potential of the second node N2 may be used to control whether the fourth transmission gate Tg4 is in an on state or an off state. When the fourth transmission gate Tg4 is in an on state, the potential of the eighth node N8 is written to the fifth node N5. When the fourth transmission gate Tg4 is in an off state, the potential of the fifth node N5 remains as the potential of the previous phase.

For example, the output signal OUT from the output terminal OUT is used to drive a PMOS transistor in the pixel circuit. The enable signal GEN controls the potential of the third node N3 by controlling the potential of the fifth node N5. By controlling the potential of the third node N3, it is possible to control whether the output terminal OUT outputs a low-level signal, thereby controlling whether the PMOS transistor is turned on and thus controlling whether to refresh the pixel circuit.

In an embodiment of the present disclosure, when the first input signal INPUT1 is a multi-width single-pulse signal, the low level of the enable signal GEN may control the output terminal OUT to output a multi-width single-pulse output signal OUT, thereby achieving refresh of the pixel circuit.

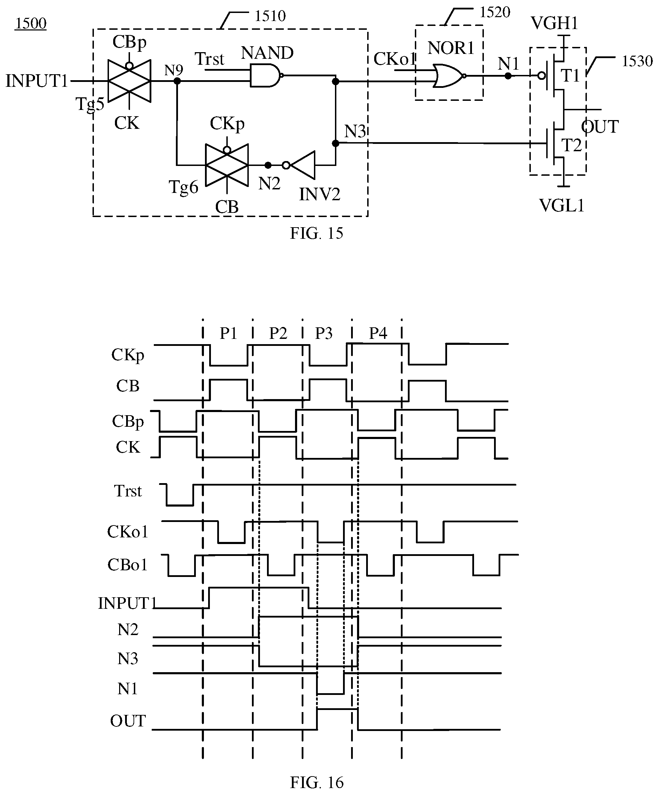

FIG. 15 shows a schematic structural diagram of a shift register according to another embodiment of the present disclosure.

As shown in FIG. 15, a shift register 1500 includes an input shift circuit 1510, a first control circuit 1520, and an output circuit 1530.

In an embodiment of the present disclosure, an output signal from the shift register 1500 is used to drive an NMOS transistor in the pixel circuit.

The input shift circuit 1510 includes a fifth transmission gate Tg5, a sixth transmission gate Tg6, a second inverter INV2, and a NAND gate NAND.

The fifth transmission gate Tg5 has a first control terminal electrically connected to the clock terminal CBp, a second control terminal electrically connected to the clock terminal CK, an input terminal electrically connected to the first input terminal INPUT1, and an output terminal electrically connected to the ninth node N9.

The sixth transmission gate Tg6 has a first control terminal electrically connected to the clock terminal CKp, a second control terminal electrically connected to the clock terminal CB, an input terminal electrically connected to the ninth node N9, and an output terminal electrically connected to the second node N2.

The second inverter INV2 has an input terminal electrically connected to the second node N2 and an output terminal electrically connected to the third node N3.

The NAND gate NAND has a first input terminal electrically connected to the reset terminal Trst and a second input terminal electrically connected to the ninth node N9.

In an embodiment of the present disclosure, the NAND gate NAND performs a NAND operation on the level of the reset signal Trst and the potential of the ninth node N9. When at least one of the level of the reset signal Trst and the potential of the ninth node N9 is at a low level, the NAND gate NAND controls the potential of the third node N3 to be at a high level. When both the level of the reset signal Trst and the potential of the ninth node N9 are at high level, the NAND gate NAND controls the potential of the third node N3 to be at a low level.

FIG. 16 shows a signal timing diagram of a shift register according to another embodiment of the present disclosure.

FIG. 16 illustrates the timing changes of various signals and the potential changes of various nodes in FIG. 15. For an operation process of the shift register 1500 shown in FIG. 15 in each time period, reference may be made to the operation process of the shift register 800 in each time period in FIG. 8B. For conciseness, details will not be repeated here.

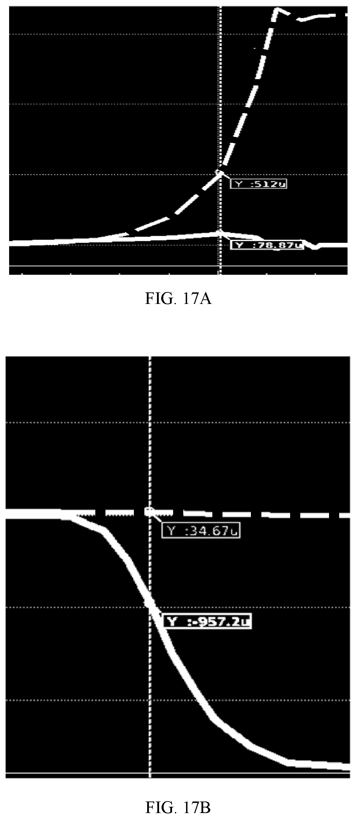

FIG. 17A and FIG. 17B show schematic current diagrams of an exemplary shift register, in which exemplary current values of leakage current in a PMOS transistor and an NMOS transistor when an output signal is output from the output terminal are shown.

FIG. 17A shows the current in the PMOS transistor and the current in the NMOS transistor when the output terminal outputs a high-level signal in the prior art.

As shown in FIG. 17A, a dashed line indicates the current in the PMOS transistor when the output terminal outputs a high-level signal, and a solid line indicates the current in the NMOS transistor when the output terminal outputs a high-level signal. Because the NMOS transistor is turned off when the output terminal outputs a high-level signal, the current in the NMOS transistor is a leakage current, and a current value of the leakage current is 78.87 µA.

FIG. 17B shows the current in the PMOS transistor and the current in the NMOS transistor when the output terminal outputs a low-level signal in the prior art.

As shown in FIG. 17B, a dashed line indicates the current in the PMOS transistor when the output terminal outputs a low-level signal, and a solid line indicates the current in the NMOS transistor when the output terminal outputs a low-level signal. Because the PMOS transistor is turned off when the output terminal outputs a low-level signal, the current in the PMOS transistor is a leakage current, and a current value of the leakage current is 34.67 µA.

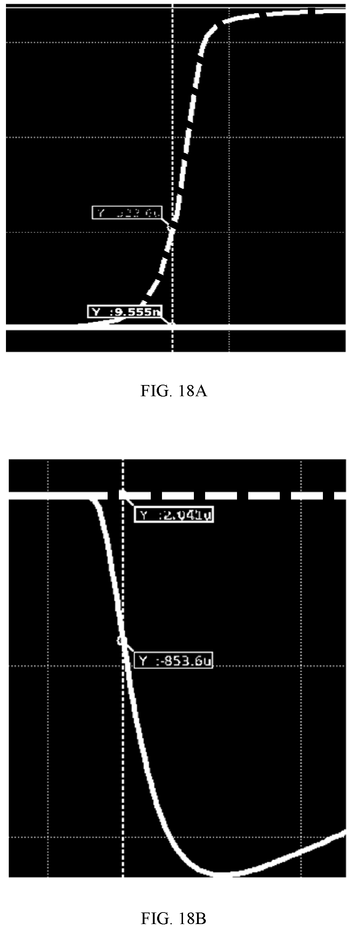

FIG. 18A and FIG. 18B show schematic current diagrams of a shift register according to an embodiment of the present disclosure, in which current values of leakage currents in the PMOS transistor and the NMOS transistor when an output signal is output from the output terminal in the shift register provided in embodiments of the present disclosure are shown.

FIG. 18A shows the currents in the PMOS transistor and the NMOS transistor when the output terminal outputs a high-level signal in embodiments of the present disclosure.

As shown in FIG. 18A, a dashed line indicates the current in the PMOS transistor when the output terminal outputs a high-level signal, and a solid line indicates the current in the NMOS transistor when the output terminal outputs a high-level signal. Because the NMOS transistor is turned off when the output terminal outputs a high-level signal, the current in the NMOS transistor is a leakage current, and a current value of the leakage current is 9.555 nA.

FIG. 18B shows the currents in the PMOS transistor and the NMOS transistor when the output terminal outputs a low-level signal in embodiments of the present disclosure.

As shown in FIG. 18B, a dashed line indicates the current in the PMOS transistor when the output terminal outputs a low-level signal, and a solid line indicates the current in the NMOS transistor when the output terminal outputs a low-level signal. Because the PMOS transistor is turned off when the output terminal outputs a low-level signal, the current in the PMOS transistor is a leakage current, and a current value of the leakage current is 2 µA.

Through the shift register provided in embodiments of the present disclosure, when the output terminal OUT outputs the output signal OUT, the current value of the leakage current in the circuit is reduced, thereby reducing the power consumption of the circuit and improving the driving capability of the circuit.

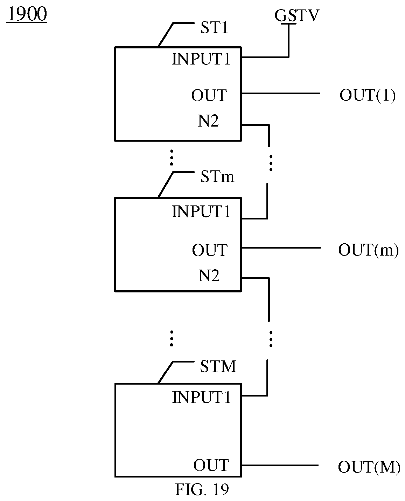

FIG. 19 shows a schematic structural diagram of a driving circuit according to an embodiment of the present disclosure.

FIG. 19 shows a schematic structural diagram of a driving circuit according to an embodiment of the present disclosure.

As shown in FIG. 19, a driving circuit 1900 includes M cascaded shift registers, where M is a positive integer greater than 1. The M shift registers include a first-stage shift register ST1, ..., an m^{th} stage shift register STm, ..., and an M^{th} stage shift register STM.

In an embodiment of the present disclosure, the shift register ST1 may be any one of the shift register 200, the shift register 300, the shift register 400, the shift register 500, the shift register 600, the shift register 700, the shift register 800, the shift register 900, the shift register 1000, the shift register 1100, the shift register 1200, the shift register 1300, the shift register 1400 or the shift register 1500 mentioned above.

For example, all the M shift registers are shift registers 300. For another example, all the M shift registers are shift registers 700. Details will not be repeated here.

In an embodiment of the present disclosure, in the cascaded M shift registers, the input signal INPUT1 of the first input terminal INPUT1 of the first-stage shift register ST1 is a start signal STV. The first input terminal INPUT1 of the m^{th} stage shift register STm is electrically connected to the second node of the (m-1)^{th} stage shift register.

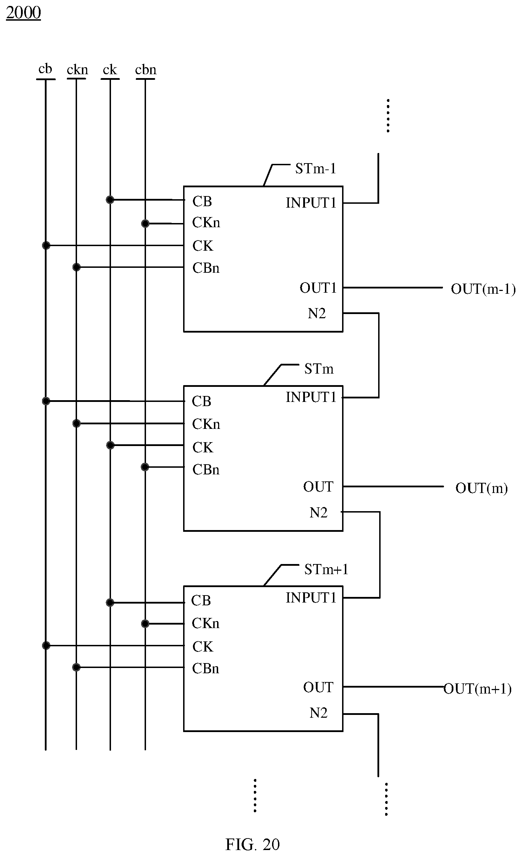

FIG. 20 shows a schematic structural diagram of a driving circuit according to another embodiment of the present disclosure.

In an embodiment of the present disclosure, a driving circuit 2000 includes M cascaded shift registers.

In an embodiment of the present disclosure, the first input terminal INPUT1 of the m^{th} stage shift register STm is electrically connected to the second node N2 of the (m-1)^{th} stage shift register STm-1, and the second node N2 of the m^{th} stage shift register STm is electrically connected to the first input terminal INPUT1 of the (m+1)^{th} stage shift register STm+1, where 2 < m ≤ M-1 and m is an integer.

In an embodiment of the present disclosure, the driving circuit 2000 further includes a first clock signal line cb, a second clock signal line ckn, a third clock signal line ck, and a fourth clock signal line cbn.

In an embodiment of the present disclosure, the first clock terminal CB of the m^{th} stage shift register STm is electrically connected to the first clock signal line cb, the second clock terminal CKn of the m^{th} stage shift register STm is electrically connected to the second clock signal line ckn, the third clock terminal CK of the m^{th} stage shift register STm is electrically connected to the third clock signal line ck, and the fourth clock terminal CBn of the m^{th} stage shift register STm is electrically connected to the fourth clock signal line cbn.

The first clock terminal CB of the (m+1)^{th} stage shift register STm+1 is electrically connected to the third clock signal line ck, the second clock terminal CKn of the (m+1)^{th} stage shift register STm+1 is electrically connected to the fourth clock signal line cbn, the third clock terminal CK of the (m+1)^{th} stage shift register STm+1 is electrically connected to the first clock signal line cb, and the fourth clock terminal CBn of the (m+1)^{th} stage shift register STm+1 is electrically connected to the second clock signal line ckn.

In an embodiment of the present disclosure, the driving circuit 2000 may include only the first clock signal line cb and the second clock signal line ckn.

In an embodiment of the present disclosure, the first clock terminal CB of the m^{th} stage shift register STm is electrically connected to the first clock signal line cb, the second clock terminal CKn of the m^{th} stage shift register STm is electrically connected to the second clock signal line ckn, the third clock terminal CK of the m^{th} stage shift register STm is electrically connected to the second clock signal line ckn, and the fourth clock terminal CBn of the m^{th} stage shift register STm is electrically connected to the first clock signal line cb.

The first clock terminal CB of the (m+1)^{th} stage shift register STm+1 is electrically connected to the second clock signal line ckn, the second clock terminal CKn of the (m+1)^{th} stage shift register STm+1 is electrically connected to the first clock signal line cb, the third clock terminal CK of the (m+1)^{th} stage shift register STm+1 is electrically connected to the first clock signal line cb, and the fourth clock terminal CBn of the (m+1)^{th} stage shift register STm+1 is electrically connected to the second clock signal line ckn.

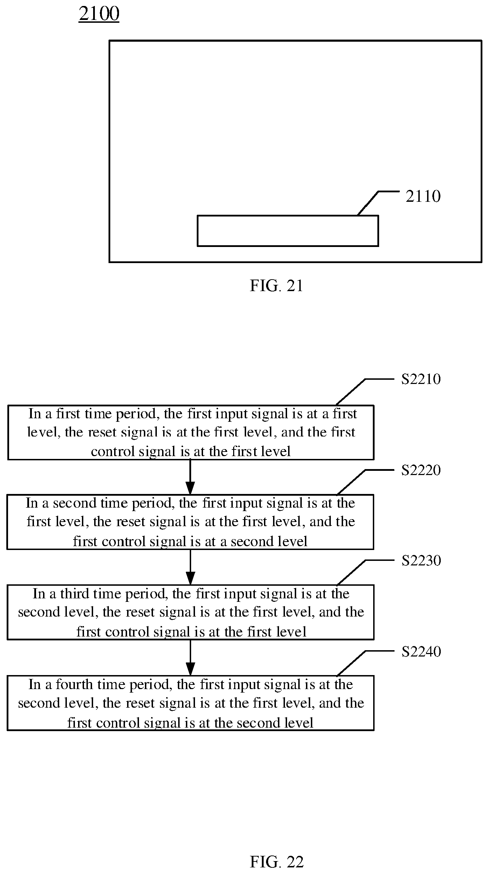

FIG. 21 shows a schematic structural diagram of a display device according to an embodiment of the present disclosure.

As shown in FIG. 21, a display device 2100 may include a driving circuit 2110.

In an embodiment of the present disclosure, the driving circuit 2110 may be at least one of the driving circuit 1900 or the driving circuit 2000 mentioned above, which will not be repeated here.

FIG. 22 shows a flowchart of a driving method according to an embodiment of the present disclosure.

As shown in FIG. 22, the driving method may include operation S2210 to operation S2240.

In operation S2210, in a first time period, the first input signal is at a first level, the reset signal is at the first level, and the first control signal is at the first level.

In operation S2220, in a second time period, the first input signal is at the first level, the reset signal is at the first level, and the first control signal is at a second level.

In operation S2230, in a third time period, the first input signal is at the second level, the reset signal is at the first level, and the first control signal is at the first level.

In operation S2240, in a fourth time period, the first input signal is at the second level, the reset signal is at the first level, and the first control signal is at the second level.

In an embodiment of the present disclosure, operation S2210 to operation S2240 are similar to the operations performed by the shift register 800 described above, which will not be repeated here.

In an embodiment of the present disclosure, the first level is a low level, and the second level is a high level. Those skilled in the art may also set the first level as a high level and the second level as a low level according to the type of transistor in the shift register.

In an embodiment of the present disclosure, in the third time period, the second clock signal is at the first level, and the first control signal transitions from the second level to the first level and then transitions from the first level to the second level.

In an embodiment of the present disclosure, the operation in the first time period is similar to that in the first time period P1 shown in FIG. 8B, the operation in the second time period is similar to that in the second time period P2 shown in FIG. 8B, the operation in the third time period is similar to that in the third time period P3 shown in FIG. 8B, and the operation in the fourth time period is similar to that in the fourth time period P4 shown in FIG. 8B. For conciseness, the same parts are not repeated here.

In an embodiment of the present disclosure, in a case of refreshing the pixel circuit in the display panel at a first frequency, the enable signal is at the first level; in a case of refreshing the pixel circuit in the display panel at a second frequency, the enable signal is at the second level; and in a case of refreshing the pixel circuit in the display panel at a third frequency, the enable signal switches between the first level and the second level, where the first frequency is greater than the third frequency, and the third frequency is greater than the second frequency.

A process of refreshing the pixel circuit in the display panel at the first frequency is similar to the operations in the first time period P1 to the fourth time period P4 shown in FIG. 12B, and a process of refreshing the pixel circuit in the display panel at the second frequency is similar to the operations in the first time period P1 to the fourth time period P4 shown in FIG. 12C. For conciseness, the same parts are not repeated here.

The flowcharts and block diagrams in the accompanying drawings illustrate architectures, functions and operations that may be implemented by systems, methods and computer program products according to various embodiments of the present disclosure. In this regard, each block in the flowcharts or block diagrams represents a module, a program segment, or a portion of code, which contains one or more executable instructions for implementing specified logical functions. It should also be noted that in some alternative implementations, the functions noted in the blocks may occur in an order different from that noted in the figures. For example, two successively represented blocks may be actually executed substantially in parallel, or may sometimes be executed in the reverse order, depending on the functions involved. It should also be noted that each block in the block diagrams or flowcharts, and combinations of blocks in the block diagrams or flowcharts, may be implemented by a dedicated hardware-based system that performs specified functions or operations, or by a combination of dedicated hardware and computer instructions.

Those skilled in the art may understand that the features described in various embodiments and/or claims of the present disclosure may be combined and/or integrated in various ways, even if such combinations or integrations are not explicitly described in the present disclosure. In particular, the features described in various embodiments and/or claims of the present disclosure may be combined and/or integrated in various ways without departing from the spirit and teachings of the present disclosure. All these combinations and/or integrations fall within the scope of the present disclosure.

Embodiments of the present disclosure have been described above. However, these embodiments are merely for illustrative purposes and are not intended to limit the scope of the present disclosure. Although the embodiments have been described separately above, this does not mean that the measures in the embodiments cannot be used in combination advantageously. The scope of the present disclosure is defined by the appended claims and their equivalents. Those skilled in the art may make various substitutions and modifications without departing from the scope of the present disclosure, and these substitutions and modifications should fall within the scope of the present disclosure.

## Claims

1. A shift register, comprising:
an input shift circuit, configured to control a potential of a first node using a first clock signal from a first clock terminal, a second clock signal from a second clock terminal, a first input signal from a first input terminal and a reset signal from a reset terminal, and to control a potential of a second node using a third clock signal from a third clock terminal, a fourth clock signal from a fourth clock terminal and the potential of the first node;
a first control circuit, configured to control a potential of a third node using the potential of the second node and a first control signal from a first control terminal; and
an output circuit, configured to control whether to provide a first power supply voltage from a first power supply or a second power supply voltage from a second power supply to an output terminal as an output signal, based on the potential of the first node and the potential of the third node.

2. The shift register according to claim 1, wherein the first control circuit comprises:
a first NOR gate, having a first input terminal electrically connected to the second node, a second input terminal electrically connected to the first control terminal, and an output terminal electrically connected to the third node.

3. The shift register according to claim 1, further comprising:
a second control circuit electrically connected to a fourth node, the first node and a second control terminal or electrically connected to the fourth node, the first node and the second clock terminal, wherein the second control circuit is configured to control the potential of the first node using a potential of the fourth node and a second control signal from the second control terminal, or to control the potential of the first node using the second clock signal and the potential of the fourth node;
wherein the input shift circuit is electrically connected to the fourth node, and the input shift circuit is further configured to control the potential of the fourth node using the first clock signal, the second clock signal, the first input signal and the reset signal.

4. The shift register according to claim 3, wherein the second control circuit is further electrically connected to the second node, and the second control circuit is further configured to control the potential of the second node using the potential of the fourth node.

5. The shift register according to claim 3 or 4, wherein the second control circuit comprises:
a first inverter, having an input terminal electrically connected to the fourth node and an output terminal electrically connected to the second node; and
a second NOR gate, having a first input terminal electrically connected to the second control terminal or the second clock terminal, a second input terminal electrically connected to the second node, and an output terminal electrically connected to the first node.

6. The shift register according to claim 1, further comprising:
a third control circuit electrically connected to an enable terminal, the first node and the second node, wherein the third control circuit is configured to control a potential of a fifth node using the potential of the first node, the potential of the second node and an enable signal from the enable terminal;
wherein the first control circuit is electrically connected to the fifth node, and the first control circuit is configured to control the potential of the third node using the potential of the fifth node and the potential of the second node.

7. The shift register according to claim 6, wherein the third control circuit comprises:
a first transmission gate, having a first control terminal electrically connected to the first node, a second control terminal electrically connected to the second node, an input terminal electrically connected to the enable terminal, and an output terminal electrically connected to the fifth node.

8. The shift register according to claim 7, wherein the first control circuit comprises:
a first NOR gate, having a first input terminal electrically connected to the second node, a second input terminal electrically connected to the first control terminal, a third input terminal electrically connected to the fifth node, and an output terminal electrically connected to the third node.

9. The shift register according to claim 1, further comprising:
a fourth control circuit electrically connected to the first node, the reset terminal, an enable terminal and a fifth node, wherein the fourth control circuit is configured to control a potential of the fifth node using the potential of the first node, the reset signal and an enable signal from the enable terminal.

10. The shift register according to claim 9, wherein the fourth control circuit comprises:
a second transmission gate, having a first control terminal electrically connected to a sixth node, a second control terminal electrically connected to a seventh node, an input terminal electrically connected to the enable terminal, and an output terminal electrically connected to the fifth node;
a third NOR gate, having a first input terminal electrically connected to the second node, a second input terminal electrically connected to the seventh node, and an output terminal electrically connected to the sixth node; and
a fourth NOR gate, having a first input terminal electrically connected to the sixth node, a second input terminal electrically connected to the reset terminal, and an output terminal electrically connected to the seventh node.

11. The shift register according to claim 1, further comprising:
a fifth control circuit electrically connected to the first node, the second node, an enable terminal, a fifth node, the first input terminal and a second input terminal, wherein the fifth control circuit is configured to control a potential of the fifth node using the potential of the first node, the potential of the second node, the first input signal, a second input signal from the second input terminal, and an enable signal from the enable terminal.

12. The shift register according to claim 11, wherein the fifth control circuit comprises:
a third transmission gate, having a first control terminal electrically connected to the first input terminal, a second control terminal electrically connected to the second input terminal, an input terminal electrically connected to the enable terminal, and an output terminal electrically connected to an eighth node; and
a fourth transmission gate, having a first control terminal electrically connected to the first node, a second control terminal electrically connected to the second node, an input terminal electrically connected to the eighth node, and an output terminal electrically connected to the fifth node.

13. The shift register according to claim 1, wherein the input shift circuit comprises:
a fifth transmission gate, having a first control terminal electrically connected to the first clock terminal, a second control terminal electrically connected to the second clock terminal, an input terminal electrically connected to the first input terminal, and an output terminal electrically connected to a ninth node;
a sixth transmission gate, having a first control terminal electrically connected to the third clock terminal, a second control terminal electrically connected to the fourth clock terminal, an input terminal electrically connected to the ninth node, and an output terminal electrically connected to the second node;
a fifth NOR gate, having a first input terminal electrically connected to the reset terminal, a second input terminal electrically connected to the ninth node, and an output terminal electrically connected to the first node; and
a second inverter, having an input terminal electrically connected to the first node and an output terminal electrically connected to the second node.

14. A driving circuit, comprising M cascaded shift registers according to any one of claims 1 to 13, wherein the first input terminal of an m^{th} stage shift register is electrically connected to the second node of an (m-1)^{th} stage shift register, 2 < m ≤ M, m and M are integers.

15. The driving circuit according to claim 14, further comprising a first clock signal line, a second clock signal line, a third clock signal line, and a fourth clock signal line;
wherein the first clock terminal of the m^{th} stage shift register is electrically connected to the first clock signal line, the second clock terminal of the m^{th} stage shift register is electrically connected to the second clock signal line, the third clock terminal of the m^{th} stage shift register is electrically connected to the third clock signal line, and the fourth clock terminal of the m^{th} stage shift register is electrically connected to the fourth clock signal line; and
wherein the first clock terminal of an (m+1)^{th} stage shift register is electrically connected to the third clock signal line, the second clock terminal of the (m+1)^{th} stage shift register is electrically connected to the fourth clock signal line, the third clock terminal of the (m+1)^{th} stage shift register is electrically connected to the first clock signal line, and the fourth clock terminal of the (m+1)^{th} stage shift register is electrically connected to the second clock signal line.

16. A display device, comprising the driving circuit according to claim 14 or 15.

17. A driving method applied to the shift register according to any one of claims 1 to 13, comprising:
controlling the first input signal to be at a first level, the reset signal to be at the first level, and the first control signal to be at the first level in a first time period;
controlling the first input signal to be at the first level, the reset signal to be at the first level, and the first control signal to be at a second level in a second time period;
controlling the first input signal to be at the second level, the reset signal to be at the first level, and the first control signal to be at the first level in a third time period; and
controlling the first input signal to be at the second level, the reset signal to be at the first level, and the first control signal to be at the second level in a fourth time period.

18. The driving method according to claim 17, wherein in the third period, the second clock signal is at the first level, and the first control signal transitions from the second level to the first level and then from the first level to the second level.

19. The driving method according to claim 17, further comprising:
controlling an enable signal to be at the first level when refreshing a pixel circuit of a display panel at a first frequency;
controlling the enable signal to be at the second level when refreshing the pixel circuit of the display panel at a second frequency; and
controlling the enable signal to switch between the first level and the second level when refreshing the pixel circuit of the display panel at a third frequency, wherein the first frequency is greater than the third frequency, and the third frequency is greater than the second frequency.
